(19) Europäisches Patentamt
European Patent Office
Office européen des brevets

(11) Veröffentlichungsnummer: **0 141 781 B1**

(12) # EUROPÄISCHE PATENTSCHRIFT

(45) Veröffentlichungstag der Patentschrift: **04.09.91**

(51) Int. Cl.5: **G03F 7/012**, G03F 7/038

(21) Anmeldenummer: **84810489.9**

(22) Anmeldetag: **08.10.84**

(54) **Strahlungsempfindliches Beschichtungsmittel und dessen Verwendung.**

(30) Priorität: **12.10.83 CH 5572/83**

(43) Veröffentlichungstag der Anmeldung:
**15.05.85 Patentblatt 85/20**

(45) Bekanntmachung des Hinweises auf die Patenterteilung:
**04.09.91 Patentblatt 91/36**

(84) Benannte Vertragsstaaten:
**BE CH DE FR GB IT LI NL SE**

(56) Entgegenhaltungen:
**EP-A- 0 020 773**
**EP-A- 0 065 352**
**EP-A- 0 119 719**
**EP-A- 0 132 221**

(73) Patentinhaber: **CIBA-GEIGY AG**
**Klybeckstrasse 141**
**CH-4002 Basel(CH)**

(72) Erfinder: **Rohde, Ottmar, Dr.**
**Bärenfelserstrasse 34**
**CH-4057 Basel(CH)**
Erfinder: **Pfeifer, Josef, Dr.**
**Brunnmattstrasse 32**
**CH-4106 Therwil(CH)**

**EP 0 141 781 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein strahlungsempfindliches Beschichtungsmittel enthaltend ein in einem organischen Lösungsmittel gelöstes Polyimid und ein organisches chromophores Polyazid, ein photographisches Aufzeichnungsmaterial für Reliefabbildungen und die Verwendung des Beschichtungsmittels zum Aufbringen von Isolier- und Schutzlacken, insbesondere Zur Herstellung von gedruckten Schaltungen, diskreten Halbleiterbauelementen und von integrierten Schaltkreisen.

Polyimide haben eine gute Thermostabilität, und sie werden daher auch in der Elektronik und Halbleitertechnologie als Isolier- und Schutzfilme eingesetzt. Dazu werden meist Reliefstrukturen benötigt, und es gilt als besonders erstrebenswert, diese Strukturen auf photolithographischem Wege durch örtliche Bestrahlung mit energiereicher Strahlung herstellen zu können. Da Polyimide im allgemeinen in organischen Lösungsmitteln unlöslich sind, geht man entweder von deren löslichen Vorstufen aus, die man nach verschiedenen Vorbehandlungen dann mittels einer zusätzlichen Beschichtung mit Photolack und Entfernen der unbedeckten Anteile strukturiert, oder man verwendet lösliche Vorstufen, die chemisch gebundene strahlungsempfindliche Gruppen tragen oder mit strahlungsempfindlichen Gruppen vermischt sind. Sowohl durch die Polyimidbildung, die erst nach der Bilderzeugung durch thermische Zyklisierung erfolgt, als auch durch die Abspaltung der photoreaktiven Seitengruppen, die einen nicht unerheblichen Anteil der Gesamtmasse ausmachen, erleiden die erzeugten Reliefstrukturen beim Erhitzen einen erheblichen Schichtdickenverlust und eine deutliche Kontraktion in den lateralen Dimensionen. Dies wird als besonders nachteilig empfunden, weil es sich als ausserordentlich schwierig erwiesen hat, naturgetreue Abbildungen einer vorgegebenen Maske zu erzeugen, und da die erzeugten Reliefbilder eine nicht unerhebliche Spannung auf das Substrat ausüben. Zudem ist bei den Systemen mit photoreaktiven Seitengruppen die aufwendige Herstellung der Vorstufen unwirtschaftlich. Durch die verschiedenen Zusätze entfalten ferner die so hergestellten Polyimide nicht die diesen Polymeren sonst eigenen guten elektrischen, Mechanischen und thermischen Eigenschaften. Solche Vorstufen und Systeme sind z.B in der DE-OS 2 308 830, DE-OS 2 914 619, der europ. Patentveröffentlichung 0 065 352 und der jap. Offenlegungsschrift 57-143329 beschrieben.

Die direkte Vernetzung durch energiereiche Strahlung und damit die Möglichkeit der direkten Photostrukturierung von Polyimiden ist zur Vermeidung der erwähnten Nachteile äusserst wünschenswert.

Es wurde nun gefunden, dass sich die genannten Nachteile, besonders Schichtdickenverluste und Kontraktionen der Reliefstrukturen in den lateralen Dimensionen sowohl nach dem Entwickeln als auch bei der thermischen Beanspruchung, durch Verwendung von Polyimiden aus bestimmten aromatischen Tetracarbonsäurederivaten und aromatischen Diaminen, bei denen beide ortho-Stellungen an einem an eine Imidgruppe des Polymeren gebundenen Phenylrest durch Alkylgruppen substiutiert sind, vermeiden lassen. Die daraus hergestellten Polyimide zeichnen sich durch gute Löslichkeit in organischen Lösungsmitteln, eine überraschend hohe Temperaturbeständigkeit (hohe Glasumwandlungstemperaturen) und eine hohe thermische Beständikeit unter Luftausschluss aus und können zusammen mit chromophoren aromatischen Polyaziden direkt durch Strahlung vernetzt werden, wobei eine hohe Auflösung der Bildstrukturen erreicht werden kann. Weiterhin können diese Polyimide auf Grund der guten löslichmachenden Wirkung der genannten Diamine noch unter Verwendung von anderen nicht unbedingt selbst löslichmachenden Comonomerbausteinen modifiziert und verbessert werden.

Gegenstand vorliegender Erfindung ist somit ein strahlungsempfindliches Beschichtungmittel, enthaltend neben üblichen Zusätzen

(a) ein organisches Lösungsmittel,

(b) ein in diesem Lösungsmittel lösliches Homo- oder Copolyimid, das im wesentlichen aus 50 bis 100 Mol.%. wiederkehrenden Strukturelementen der Formeln Ia und/oder Ib

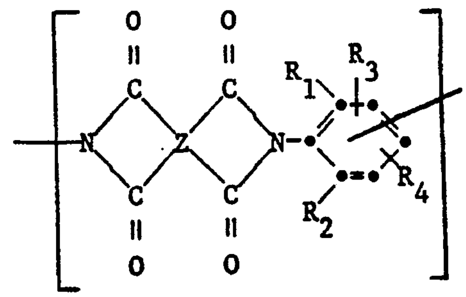

(Ia) und/oder

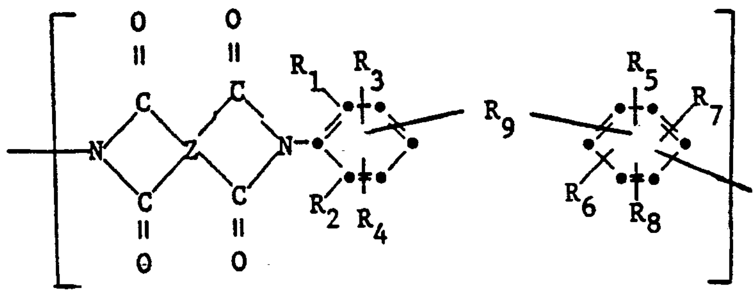

(Ib)

und 50 bis 0 Mol.% wiederkehrenden Strukturelementen der Formel II

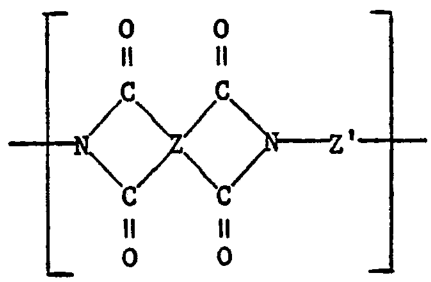

(II)

besteht, und (c) mindestens 0,1 Gew.%, bezogen auf die Komponente (b), mindestens eines organischen chromophoren Polyazids, in dem die Azidgruppen direkt oder über eine $SO_2$-Gruppe an aromatische Kohlenwasserstoffe gebunden sind, wobei in den Formeln Ia, Ib und II die vier Carbonylgruppen an verschiedene Kohlenstoffatome gebunden sind und je zwei Carbonylgruppen in ortho- oder peri-Stellung zueinander stehen,

Z einen vierwertigen Rest bedeutet, der mindestens einen aromatischen Ring enthält,

Z' einen von Gruppen

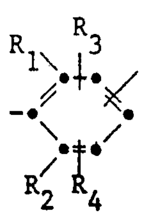

oder

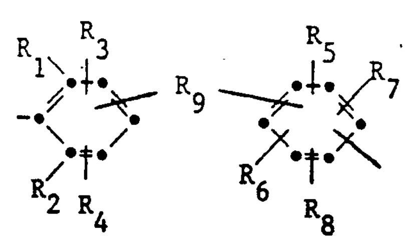

verschiedenen zweiwertigen organischen Rest darstellt, ausgewählt unter aromatischen, alkylaromatischen, aliphatischen, cycloaliphatischen und heterocyclischen Resten, Kombinationen davon und Resten mit Sauerstoff, Schwefel, Stickstoff, Silicium oder Phosphor enthaltenden Brückengruppen,

$R_1$ und $R_2$ unabhängig voneinander Alkyl mit 1-4 C-Atomen,

$R_3$, $R_4$, $R_5$, $R_6$, $R_7$ und $R_8$ unabhängig voneinander Wasserstoff oder Alkyl mit 1-4 C-Atomen und

$R_9$ die direkte Bindung, -O-, -S-, -SO-, -S-S-, $-SO_2-$, -CO-. -COO-, -NH-,

-N-Alkyl

mit 1-6 C-Atomen im Alkyl,

-N-Phenyl,

-N-Benzyl,

-CONH-,

-CON-Alkyl

mit 1-6 C-Atomen im Alkyl,

-CON-Phenyl, -CON-Benzyl,

eine lineare oder verzweigte Alkylengruppe mit 1-3 C-Atomen, Alkyliden mit 2-12 C-Atomen, Cycloalkyliden mit 5-6 Ringkohlenstoffatomen, Phenylen,

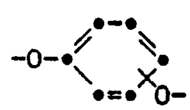

oder eine Gruppe

$R_{10}Si-R_{11}$,

bedeuten, worin $R_{10}$ und $R_{11}$ Alkyl oder Alkoxy mit je 1-6 C-Atomen, Phenyl, Benzyl, Phenyloxy oder Benzyloxy darstellen.

Bei den Copolyimiden kann es sich um statistische Polymere oder um Blockcopolymere handeln. Der Polymerisationsgrad (Zahl der wiederkehrenden Strukturelemente) beträgt bevorzugt mindestens 20 und kann 1000 und mehr betragen. Besonders bevorzugt ist ein Polymerisationsgrad von 50 bis 500 und besonders von 100 bis 300.

Alkylgruppen $R_1$ bis $R_8$, $R_{10}$ und $R_{11}$, Alkylgruppen in Resten $R_9$ sowie Alkoxygruppen $R_{10}$ und $R_{11}$ können geradkettig oder verzweigt sein. Als Beispiele seien genannt: Methyl, Aethyl, n-Propyl, Isopropyl, n-Butyl, sek-Butyl, tert-Butyl, n-Pentyl, 2-Pentyl, n-Hexyl, Methoxy, Aethoxy, n-Propoxy, Isopropoxy, n-Butoxy, n-Pentyloxy und n-Hexyloxy. Stellt $R_9$ eine Gruppe

-N-Alkyl

oder

-CON-Alkyl

dar, so handelt es sich insbesondere um die Gruppen

$$-\overset{|}{N}C_2H_5$$

oder

$$-CO\overset{|}{N}C_2H_5$$

und ganz besonders um die Gruppen

$$-\overset{|}{N}CH_3$$

oder

$$-CO\overset{|}{N}CH_3.$$

$R_9$ als lineare oder verzweigte Alkylengruppe ist vorzugsweise Aethylen und besonders Methylen. Stellt $R_9$ eine Alkyliden- oder Cycloalkylidengruppe dar, so handelt es sich z.B. um die Aethyliden-, 1,1- oder 2,2-Propyliden-, 1,1- oder 2,2-Butylidengruppe bzw. um eine Cyclopentyliden- oder Cyclohexylidengruppe. Als Alkylidengruppe $R_9$ ist die 2,2-Propylidengruppe (Isopropylidengruppe) bevorzugt. Dialkyl- und Dialkoxysilylgruppen

$$R_{10}-\overset{|}{\underset{|}{Si}}-R_{11}$$

weisen in den Alkyl- oder Alkoxygruppen bevorzugt 1 oder 2 C-Atome auf. Die Z und Z' können in den einzelnen Strukturelementen unterschiedliche Bedeutungen haben.

$R_1$ und $R_2$ sind bevorzugt unabhängig voneinander Methyl oder Aethyl. $R_3$ bis $R_8$ sind bevorzugt unabhängig voneinander Wasserstoff, Methyl oder Aethyl, $R_9$ ist bevorzugt $-CH_2-$, -0-, -CO- oder die direkte Bindung.

Unter den Polyimiden und Copolyimiden mit wiederkehrenden Strukturelementen der Formel Ia sind solche bevorzugt, worin $R_1$ und $R_2$ je Aethyl und insbesondere je Methyl und $R_3$ und $R_4$ unabhängig voneinander Wasserstoff oder Methyl bedeuten. Dabei befindet sich die freie Bindung bevorzugt in meta- und insbesondere in para-Stellung zum N-Atom. Insbesondere handelt es sich um Polyimide oder Copolyimide, die sich von Diaminen der Formeln A, B, C oder D

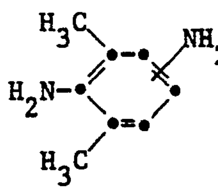 (A), 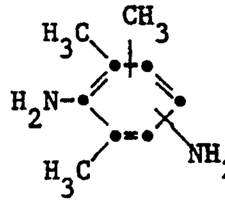 (B) ,

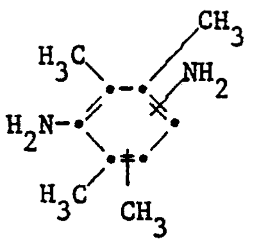

(C) oder

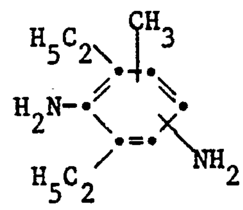

(D)

oder Gemischen davon ableiten, worin sich die Aminogruppen in meta- und vor allem in para-Stellung zueinander befinden.

Unter den Polyimiden oder Copolyimiden mit wiederkehrenden Strukturelementen der Formel Ib sind solche bevorzugt, die sich von symmetrischen Diaminen der Formel III

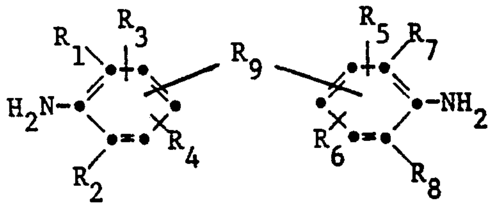

(III)

ableiten, worin $R_9$ die oben angegebene Bedeutung hat und insbesondere die direkte Bindung, $-CH_2-$ oder -CO- darstellt, $R_1$, $R_2$, $R_7$ und $R_8$ je $C_1$-$C_4$-Alkyl darstellen, $R_3$ und $R_5$ bzw. $R_4$ und $R_6$ dieselbe Bedeutung haben und Wasserstoff oder $C_{1-4}$-Alkyl darstellen. Besonders bevorzugt stellen $R_3$ bis $R_6$ Wasserstoff dar und $R_1$, $R_2$, $R_7$ und $R_8$ sind $C_{1-4}$-Alkyl, besonders Aethyl und vor allem Methyl. Ganz besonders bevorzugt sind Polyimide oder Copolyimide mit wiederkehrenden Strukturelementen der Formel Ib, die sich von Diaminen der Formel IIIa

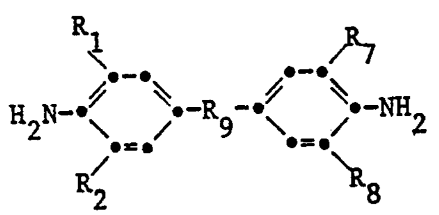

(IIIa)

ableiten, worin $R_1$ und $R_7$ Methyl sind, $R_2$ und $R_8$ Aethyl und vor allem Methyl darstellen und $R_9$ die direkte oder -CO- und insbesondere $-CH_2-$ bedeutet.

Als spezifische Beispiele von Diaminen, die zur Herstellung solcher Polyimide mit Strukturelementen der Formel Ia oder Ib geeignet sind, seien genannt: 1,4-Diamino-2,3,5,6-tetramethylbenzol (Duroldiamin), 1,3-Diamino-2,4,5,6-tetramethylbenzol (Isoduroldiamin), 1,4-Diamino-2,5,6-trimethylbenzol, 1,3-Diamino-2,4,6-trimethyl- und -2,5,6-trimethylbenzol, 1,3-Diamino-2,6-diäthyl-4-methylbenzol, 1,4-Diamino-2,6-diäthyl-3-methylbenzol, 1,4-Diamino-2,6-dimethylbenzol, 1,3-Diamino-2,6-dimethylbenzol, 4,4'-Diamino-3,3',5,5'-tetramethyldiphenylmethan, 3,3'-Diamino-2,2,'-4,4'-tetramethyldiphenylmethan, 4,4'-Diamino-3,3'-diäthyl-5,5'-dimethyldiphenylmethan, 4,4'-Diamino-2,2',3,3',5,5',-6,6'-octamethyldiphenylmethan, 4,4'-Diamino-3,3',5,5'-tetramethylbenzophenon.

Z kann z.B. einen Phenylindanrest der Formel IV

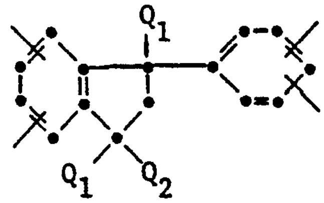

(IV)

darstellen, worin $Q_1$ Wasserstoff oder Alkyl mit 1 bis 5 Kohlenstoffatomen und $Q_2$ Alkyl mit 1 bis 5 Kohlenstoffatomen bedeuten,
Beispiele für Phenylindandianhydrid-Komponenten mit einem Rest der Formel IV sind:
1- (3',4,-Dicarboxyphenyl)-1,3,3-trimethylindan-5,6-dicarbonsäuredianhydrid,
1-(3',4'-Dicarboxyphenyl)-1,3,3-trimethylindan-6,7-dicarbonsäuredianhydrid,
1-(3',4'-Dicarboxyphenyl)3-methylindan-5,6-dicarbonsäuredianhydrid und
1-(3',4'-Dicarboxyphenyl)-3-methylindan-6,7-dicarbonsäureanhydrid.

Z kann als Nichtphenylindanrest aus den folgenden Gruppen ausgewählt sein: aromatischen, aliphatischen, cycloaliphatischen und heterocyclischen Gruppen, Kombinationen von aromatischen und aliphatischen Gruppen. Die Gruppen können auch substituiert sein. Die Gruppen Z entsprechen vorzugsweise einer oder mehrerer der folgenden Strukturen:

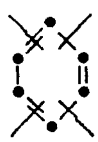
(1),
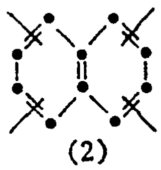
(2),
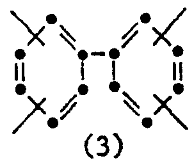
(3),
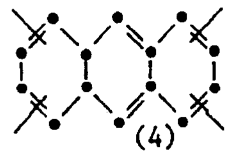
(4),
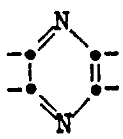
(5),
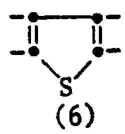
(6),
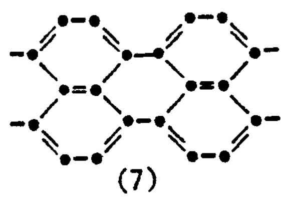
(7),
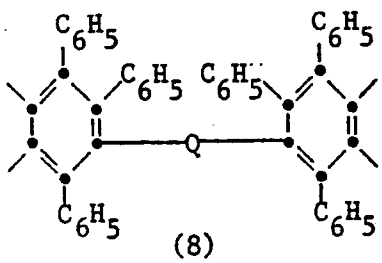
(8),
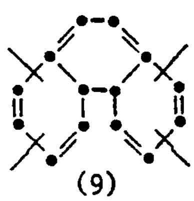
(9)
und
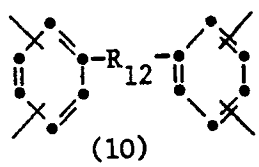
(10),

worin Q 1,3- oder 1,4-Phenylen oder einen Diphenylätherrest darstellt und $R_{12}$ ausgewählt ist aus der Gruppe, bestehend aus

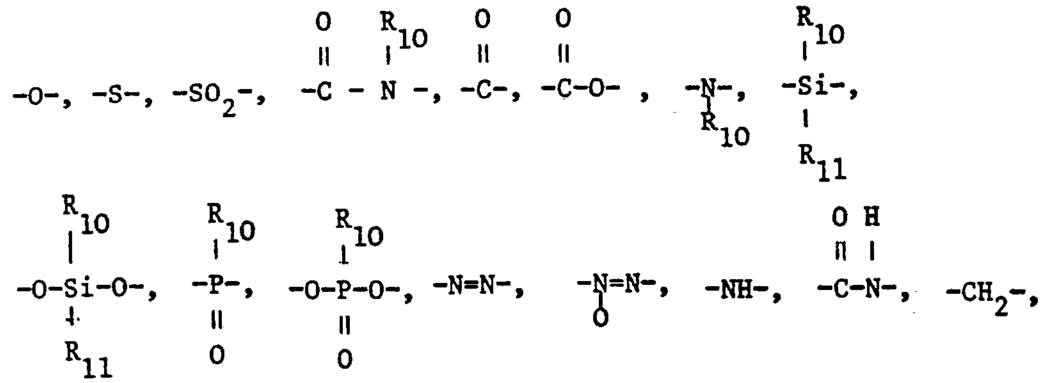

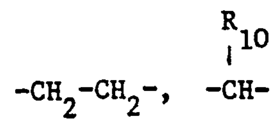 und 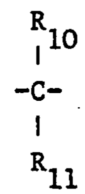 ,

wobei $R_{10}$ und $R_{11}$ Alkyl oder Alkoxy mit je 1 bis 6 C-Atomen, Phenyl, Benzyl, Phenyloxy oder Benzyloxy bedeuten. Tetracarbonsäuredianhydride, worin Z einen Rest der Formel (8) darstellt, sind z.B. in F.W. Harris und R.B. Seymour: "Structure and Solubility Relationships in Polymers", Academic Press, New York, S. 183-198 (1977) beschrieben.

Geeignete Tetracarbonsäuredianhydride mit einem vierwertigen Rest Z sind z.B.
2,3,9,10-Perylentetracarbonsäuredianhydrid,
1,4,5,8-Naphthalintetracarbonsäuredianhydrid,
2,6-Dichlornaphthalin-1,4,5,8-tetracarbonsäuredianhydrid,
2,7-Dichlornaphthalin-1,4,5,8-tetracarbonsäuredianhydrid,
2,3,6,7-Tetrachlornaphthalin-1,4,5,8-tetracarbonsäuredianhydrid,
Phenanthren-1,8,9,10-tetracarbonsäuredianhydrid,
2,3,3',4'-Benzophenontetracarbonsäuredianhydrid,
Pyromellitsäuredianhydrid,
3,3',4,4'- Benzophenontetracarbonsäuredianhydrid,
2,2',3,3'-Benzophenontetracarbonsäuredianhydrid,
3,3',4,4'-Biphenyltetracarbonsäuredianhydrid,
2,2',3,3'-Biphenyltetracarbonsäuredianhydrid,
4,4'-Isopropylidendiphthalsäureanhydrid,
3,3'-Isopropylidendiphthalsäureanhydrid,
4,4'-Oxydiphthalsäureanhydrid,
3,3'-Oxydiphthalsäureanhydrid,
4,4'-Sulfonyldiphthalsäureanhydrid,
4,4'-Methylendiphthalsäureanhydrid,
4,4'-Hydroxymethylendiphthalsäureanhydrid,
4,4'-Thiodiphthalsäureanhydrid,
4,4'-Aethylidendiphthalsäureanhydrid,
2,3,6,7-Naphthalintetracarbonsäuredianhydrid,
1,2,4,5-Naphthalintetracarbonsäuredianhydrid,
1,2,5,6-Naphthalintetracarbonsäuredianhydrid,
Benzol-1,2,3,4-tetracarbonsäuredianhydrid,
Pyrazin-2,3,5,6-tetracarbonsäuredianhydrid,
Thiophen-2,3,4,5-tetracarbonsäuredianhydrid,
1-(3',4'-Dicarboxyphenyl)-1,3,3-trimethylindan-5,6-dicarbonsäuredianhydrid,
1-(3',4'-Dicarboxyphenyl)-1,3,3-trimethylindan-6,7-dicarbonsäuredianhydrid,
1-(3',4'-Dicarboxyphenyl)-3-methylindan-5,6-dicarbonsäuredianhydrid,

Tetrahydrofurantetracarbonsäuredianhydrid,
Cyclopentantetracarbonsäuredianhydrid,
Cyclooctantetracarbonsäuredianhydrid und
1, (3',4'-Dicarboxyphenyl)-3-methylindan-6,7-dicarbonsäuredianhydrid und Dianhydride der allgemeinen Formel V

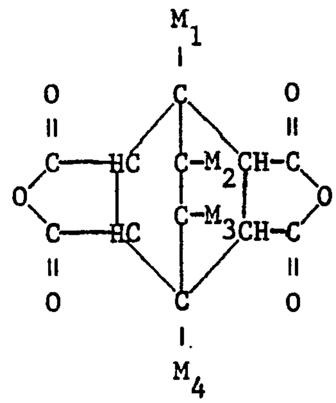

(V),

worin $M_1$, $M_2$, $M_3$ und $M_4$ unabhängig voneinander Wasserstoff oder Alkyl mit je 1-6 C-Atomen, besonders Methyl, darstellen.

Besonders bevorzugt ist Z der Rest des Pyromellitsäuredianhydrids, ein Rest der Formel VI

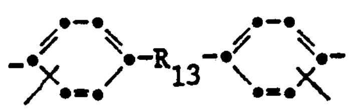

(VI)

oder ein Gemisch dieser Reste, worin $R_{13}$ die direkte Bindung, $-CH_2-$, -O-, $-SO_2-$ oder -CO- ist.

Ganz besonders bevorzugt ist Z der Rest des Pyromellitsäuredianhydrids, ein Rest der Formel VIa

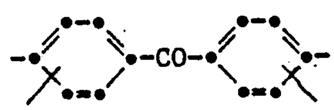

(VIa)

oder ein Gemisch dieser Reste.

Die vorstehend definierte Gruppe Z' kann ausgewählt werden unter Alkylengruppen mit 2-12 C-Atomen, Cycloalkylengruppen mit 4-6 Ringkohlenstoffatomen; einer Xylylengruppe, gegebenenfalls substituierten Arylengruppen, z.B. ortho-, meta- oder para-Phenylen, Tolylen, halogen-substituiertem Phenylen, Naphthylen oder Anthrylen; einer bicyclischen aromatischen Verbindung der Formel VII

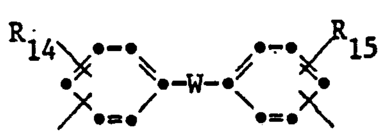

(VII),

worin W eine direkte Bindung, -S-, -CO-, -NH-,

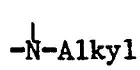

mit 1-5 C-Atomen im Alkyl, -O-, -SO-, -S-S-,

-N-Phenyl,

$-SO_2-$, eine lineare oder verzweigte Alkylengruppe mit 1-3 C-Atomen, Alkyliden mit 2-12 C-Atomen, Cycloalkyliden mit 5 oder 6 Ringkohlenstoffatomen, Phenylen oder eine Gruppe

$R_{10}-Si-R_{11}$

darstellt, $R_{14}$ und $R_{15}$ unabhängig voneinander jeweils Wasserstoff, Halogen, besonders Chlor oder Brom, Alkyl oder Alkoxy mit 1-5 C-Atomen, besonders Methyl oder Methoxy, oder Aryl, besonders Phenyl,bedeuten und $R_{10}$ und $R_{11}$ die oben angegebene Bedeutung haben. Beispiele von geeigneten Alkyliden-, Cycloalkyliden- oder

$R_{10}-Si-R_{11}$-

-Gruppen sind unter $R_9$ erwähnt. Reste der Formel VII sind vorzugsweise in 3,3'- und vor allem in 4,4'-Stellung gebunden.

Weiter kann die Gruppe Z' der Formel VIII oder IX

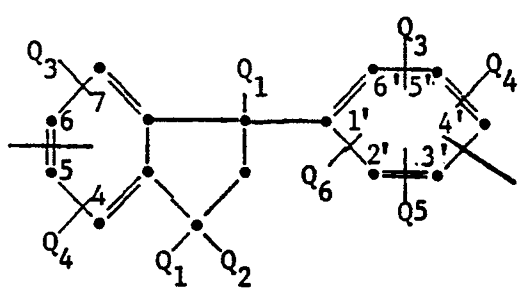

oder

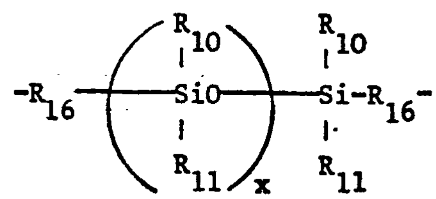

(VIII) (IX)

entsprechen, worin $Q_1$, $Q_2$, $R_{10}$ und $R_{11}$ die oben angegebene Bedeutung haben, $Q_3$, $Q_4$, $Q_5$ und $Q_6$ unabhängig voneinander Wasserstoff, Alkyl oder Alkoxy mit je 1-4 C-Atomen oder Halogen bedeuten, $R_{16}$ ein zweiwertiger Kohlenwasserstoffrest ist, z.B. Cycloalkylen mit 5 oder 6 Ringkohlenstoffatomen oder Phenylen und insbesondere Alkylen mit 1-12, vorzugsweise 1-6 C-Atomen, und x eine ganze Zahl von 1-50 bedeutet. Diamine mit dieser Gruppe Z' sind in der US-PS 4.030.948 beschrieben. Bevorzugt sind Gruppen der Formel IX, worin x die Zahl 1, die $R_{10}$ $R_{11}$ je Methyl und $R_{16}$ Alkylen mit 1-6 und vor allem 3 C-Atomen bedeuten.

$Q_1$ und $Q_2$ können in ihrer Bedeutung als Alkyl Methyl, Aethyl, Propyl, iso-Propyl, n-Butyl und n-Pentyl sein. Besonders bevorzugt sind $Q_1$ Wasserstoff oder Methyl und $Q_2$ Methyl.

$Q_3$, $Q_4$, $Q_5$ und $Q_6$ sind in ihrer Bedeutung als Halogen bevorzugt Chlor oder Brom. Alkoxyreste $Q_3$, $Q_4$, $Q_5$ und $Q_6$ sind z.B. n-Butoxy, n-Propoxy, Aêthoxy und besonders Methoxy; Alkylreste $Q_3$, $Q_4$, $Q_5$ und $Q_6$ sind z.B. n-Butyl, tertiär-Butyl, n-Propyl, iso-Propyl, Aethyl und besonders Methyl. Besonders bevorzugt sind $Q_3$, $Q_4$, $Q_5$ und $Q_6$ unabhängig voneinander Wasserstoff, Methyl oder Chlor.

Die Phenylindandiamin-Komponente des Polyimids kann aus jeder Kombination von isomeren oder substituierten isomeren Resten der Formel VIII bestehen. So kann die Phenylindandiamin-Komponente z.B. 0 bis 100 Mol-% 5-Amino-1-(4'-aminophenyl)-1,3,3-trimethylindan in Kombination mit 100 bis 0 Mol-% 6-Amino-1-(4'-aminophenyl)-1,3,3-trimethylindan umfassen. Beispiele für substituierte Diamino-Isomere, die als Ausgangsprodukte verwendet werden können, sind 5-Amino-6-methyl-1-(3'-amino-4'-methylphenyl)-1,3,3-trimethylindan, 5-Amino-1-(4'-amino-Ar',Ar'-dichlorphenyl)-Ar,Ar-dichlor-1,3,3-trimethylindan, 6-Amino-1-(4'-amino-Ar',Ar'-dichlorphenyl)-Ar,Ar-dichlor-1,3,3-trimethylindan, 4-Amino-6-methyl-1-(3'-amino-4'-methylphenyl)-1,3,3-trimethylindan und Ar-amino-1-(Ar'-amino-2',4'-dimethylphenyl)-1,3,3,4,6-pentamethylindan. Ar und Ar' in den genannten Verbindungen zeigen die unbestimmte Lage der angegebenen Substituenten

in den Phenylringen an. Die Aminogruppen befinden sich bevorzugt in der Stellung 7, besonders 5 und 6, und der Stellung 3' und besonders 4'.

Bevorzugt ist Z' eine Gruppe der Formel X

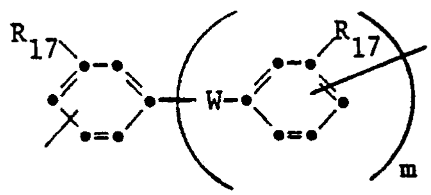

(X),

worin W die oben angegebene Bedeutung hat und vor allem eine direkte Bindung, -O-, -CO- oder $-CH_2-$ bedeutet, m Null oder 1 ist, die freien Bindungen sich in meta- und bevorzugt in ortho-Stellung zur Gruppe $R_{17}$ befinden und $R_{17}$ ein Wasserstoffatom, Alkyl oder Alkoxy mit je 1-5 C-Atomen, besonders Methyl, Aethyl, Isopropyl, Methoxy, Aethoxy, oder ein Wasserstoffatom, bedeutet.

Beispiele für Diamine mit einem Zweiwertigen Rest Z' sind:

m- und p-Phenylendiamin, 4,4'- und 3,3'-Diaminobiphenyl, 4,4'- und 3,3'-Diaminodiphenyläther, 4,4'- und 3,3'-Diaminodiphenylmethan, 4,4'- und 3,3'-Diaminodiphenylsulfon, 4,4'- und 3,3'-Thiodianilin, Bis-(4-aminophenyl)bis(trifluormethyl)methan, 4,4'-Diaminobenzophenon, 1,5-Diaminonaphthalin, Bis-(4-aminophenyl)-dimethylsilan, Bis-(4-aminophenyl)-diäthylsilan, Bis(4-aminophenyl)-diphenylsilan, Bis-(4-aminophenyloxy)-dimethylsilan, Bis-(4-aminophenyl)-äthylphosphinoxid, N-[Bis-(4-aminophenyl)]-N-methylamin, N-[Bis-(4-aminophenyl)]-N-phenylamin, 4,4'-Methylenbis-(o-chloranilin), 4,4'-Methylenbis-(3-methylanilin), 4,4'-Methylenbis-(2-äthylanilin), 4,4'-Methylenbis-(2-methoxyanilin),5,5'-Methylenbis-(2-aminophenol), 4,4'-Methylenbis-(2-methylanilin), 4,4'-Oxybis-(2-methoxyanilin), 4,4'-Oxybis-(2-chloranilin), 5,5'-Oxybis-(2-aminophenol), 4,4'-Thiobis-(2-methylanilin), 4,4'-Thiobis-(2-methoxyanilin), 4,4'-Thiobis-(2-chloranilin), 4,4'-Sulfonylbis-(2-methylanilin), 4,4'-Sulfonylbis-(2-äthoxyanilin),4,4'-Sulfonylbis-(2-chloranilin), 5,5'-Sulfonylbis-(2-aminophenol), 3,3'-Dimethyl-4,4'-diaminobenzophenon, 3,3'-Dimethoxy-4,4'-diaminobenzophenon, 3,3'-Dichlor-4,4'-diaminobenzophenon, 4,4'-Oxydianilin, 4,4'-Isopropylidendianilin, 3,3'-Dichlorbenzidin, 3,3'-Dimethylbenzidin, 3,3'-Dimethoxybenzidin, 3,3'-Dicarboxybenzidin, Diaminotoluol, 4,4'-Methylen-bis-(3-carboxyanilin) und dessen Ester, 5-Amino-1-(4-aminophenyl)1,3,3-trimethylindan und 6-Amino-1-(4'-aminophenyl)-1,3,3-trimethylindan.

Die für die Herstellung der definitionsgemässen Polyimide verwendeten Tetracarbonsäurederivate und Diamine sind bekannt oder können nach an sich bekannten Verfahren hergestellt werden. Die Polyimide können auf an sich bekannte Weise durch Kondensation bzw. Co-Kondensation entsprechender Tetracarbonsäurederivate, vor allem der Dianhydride, mit den Diaminen und anschliessende Cyclisierung der Polyamidsäuren hergestellt werden. Gewünschtenfalls können auch so erhaltene Polyamidsäureblöcke mit geeigneten Endgruppen miteinander oder mit entsprechenden Monomeren (Tetracarbonsäurederivaten und Diaminen) umgesetzt und anschliessend cyclisiert werden.

Eine bevorzugte Untergruppe von löslichen Homo- oder Copolymeren (b) für die erfindungsgemässen Beschichtungsmittel sind solche, die im wesentlichen aus 70 bis 100 Mol.% wiederkehrenden Strukturelementen der Formel Ia oder Ib oder Gemischen davon und 30 bis 0 Mol.% wiederkehrenden Strukturelementen der Formel II bestehen, worin Z der Rest des Pyromellitsäureanhydrids, ein Rest der Formel VI oder ein Gemisch dieser Reste ist, $R_1$ und $R_2$ unabhängig voneinander Methyl oder Aethyl, $R_3$ bis $R_8$ unabhängig voneinander Wasserstoff, Methyl oder Aethyl und $R_9$ $-CH_2-$, -O-, -CO- oder die direkte Bindung bedeuten, und Z' ein Rest der Formel X ist, wobei $R_{13}$, m, $R_{17}$ und W die oben angegebene Bedeutung haben, oder Z' ein Rest der Formel IX ist, worin x, $R_{10}$ und $R_{11}$ die oben angegebene Bedeutung haben und $R_{16}$ Alkylen mit 1-6 C-Atomen darstellt.

Besonders bevorzugt sind Beschichtungsmittel mit Homo- oder Copolyimiden (b), die im wesentlichen aus 70 bis 100 Mol.% wiederkehrenden Strukturelementen der Formel Ia oder Ib oder Gemischen davon und 30 bis 0 Mol.% wiederkehrenden Strukturelementen der Formel II bestehen,worin Z der Rest des Pyromellitsäuredianhydrids, ein Rest der Formel VIa oder ein Gemisch dieser Reste ist, und worin die Strukturelemente der Formel Ia von Diaminen der Formeln A, B, C oder D oder Gemischen davon und die Strukturelemente der Formel Ib von Diaminen der Formel IIIa abgeleitet sind, wobei $R_1$, $R_2$, $R_7$, $R_8$ und $R_9$ die unter Formel IIIa angegebene Bedeutung haben, und Z' ein Rest der Formel X ist, worin m Null oder 1 darstellt, W die direkte Bindung, -CO- oder $-CH_2-$ und insbesondere -O- ist und $R_{17}$ ein Wasserstoffatom bedeutet.

Ebenfalls bevorzugt sind erfindungsgemässe Beschichtungsmittel, worin das Homo- oder Copolyimid

(b) im wesentlichen aus 70 bis 100 Mol.% wiederkehrenden Strukturelementen der Formel Ia oder Ib oder Gemischen davon und 30 bis 0 Mol.% wiederkehrenden Strukturelementen der Formel II besteht, worin Z der Rest des Pyromellitsäureanhydrids, ein Rest der Formel VIa oder ein Gemisch dieser Reste ist, und worin die Strukturelemente der Formel Ia von Diaminen der Formeln A, B, C oder D oder Gemischen davon und die Strukturelemente der Formel Ib von Diaminen der Formel IIIa abgeleitet sind, wobei $R_1$, $R_2$, $R_7$, $R_8$ und $R_9$ die unter Formel IIIa angegebene Bedeutung haben, und Z' ein Rest der Formel IX ist, worin x die Zahl 1, die $R_{10}$ und $R_{11}$ je Methyl und $R_{16}$ Alkylen mit 1-6 und insbesondere 3-C-Atomen bedeuten.

Ganz besonders bevorzugt sind Homo- oder Copolyimide (b), die aus 100 Mol.% wiederkehrenden Strukturelementen der Formel Ia oder Ib oder Gemischen davon bestehen, worin Z den Rest des Pyromellitsäuredianhydrids, ein Rest der Formel VIa oder ein Gemisch dieser Reste ist, und worin die Strukturelemente der Formel Ia von Diaminen der Formeln A, B, C oder D oder Gemischen davon und die Strukturelemente der Formel Ib von 4,4'-Diamino-3,5,3'5'-tetramethyldiphenylmethan abgeleitet sind.

Unter den Polyimiden sind solche bevorzugt, die eine hohe Temperaturbeständigkeit aufweisen. Besonders bevorzugt sind solche Polyimide, die sich an der Luft bei einer Temperatur bis 350° C und mehr nicht zersetzen. Zur Beurteilung der Güte der Beschichtungen können die elektrischen Eigenschaften, wie Dielektrizitätkonstante, Verlustfaktor und Durchschlagspannung, verwendet werden, insbesondere auch der spezifische Durchgangswiderstand (DIN 53482),gemessen unter standardisierten Bedingungen. Dabei ist es wünschenswert, dass auch unter längerer thermischer Belastung ein Wert in der Grössenordnung von $10^{16}$ ohm•cm oder mehr erreicht wird. Es ist ferner bekannt, dass für eine gute Photostrukturierung von polymeren Materialien diese eine möglichst enge Molekulargewichtsverteilung aufweisen sollen. Es hat sich als sehr vorteilhaft erwiesen, die löslichen Polyimide mittels bekannter Trennmethoden, wie fraktioniertes Fällen, vorzubehandeln, um Beschichtungsmittel mit enger Molekulargewichtsverteilung zu erhalten. Es ist ferner bekannt, dass die Strahlungsempfindlichkeit mit dem mittleren Molekulargewicht $\overline{M}_w$ anwächst. Ein mittleres Molekulargewicht von 10'000 bis 500'000, bevorzugt 20'000 bis 300'000 und besonders 30'000 bis 200'000, hat sich als günstig erwiesen.

Geeignete organische Lösungsmittel, in denen die Homo- und Copolyimide (b) gegebenenfalls unter Erwärmen gelöst werden können, sind polare, besonders polare aprotische Lösungsmittel, die alleine oder in Mischungen aus mindestens zwei Lösungsmitteln verwendet werden können. Geeignete Lösungsmittel sind z.B.: Aether, wie Dibutyläther, Tetrahydrofuran, Dioxan, Methyläthylenglykol, Dimethyläthylenglykol, Dimethyldiäthylenglykol, Diäthyldiäthylenglykol, Dimethyltriäthylenglykol; halogenierte aliphatische Kohlenwasserstoffe, wie Methylenchlorid, Chloroform, 1,2-Dichloräthan, 1,1,2-Trichloräthan, 1,1,2,2-Tetrachloräthan; Carbonsäureester und Lactone, wie Essigsäureäthylester, Propionsäuremethylester, Benzoesäureäthylester, 2-Methoxyäthylacetat, $\gamma$-Butyrolacton, $\delta$-Valerolacton und Mevalolacton; Carbonsäureamide und Lactame, wie Formamid, Acetamid, N-Methylformamid, N,N-Dimethylformamid, N,N-Diäthylformamid, N,N-Dimethylacetamid, N,N-Diäthylacetamid, $\gamma$-Butyrolactam, $\epsilon$-Caprolactam, N-Methylpyrrolidon, N-Acetylpyrrolidion, N-Methylcaprolactam, Tetramethylharnstoff, Hexamethylphosphorsäureamid; Sulfoxide,wie Dimethylsulfoxid; Sulfone, wie Dimethylsulfon, Diäthylsulfon, Trimethylensulfon, Tetramethylensulfon; primäre, sekundäre und tertiäre Amine, wie Methylamin, Aethylamin, Propylamin, Pyrrolidin, Piperidin, Morpholin, Dimethylamin, Diäthylamin, Methyläthylamin, Trimethylamin, Triäthylamin, N-Methylpyrrolidin, N-Methylpiperidin, N-Methylmorpholin; substituierte Benzole,wie Chlorbenzol, Nitrobenzol, Kresol; cycloaliphatische Ketone, wie Cyclopentanon, Cyclohexanon, Cycloheptanon, 2-Methylcyclohexanon, 3-Methylcyclohexanon und 4-Methylcyclohexanon; aromatische Ketone, wie Acetophenon und Propionphenon.

Die Polyazide (c) sind bekannt und z.B. in der EP-A 0 065 352 beschrieben. Sie können alleine oder in beliebigen Mischungen eingesetzt werden.

Die aromatischen Kohlenwasserstoffreste der chromophoren Polyazide (c) können durch 1 bis 2 Halogenatome, besonders Chlor, und Alkoxy- oder Alkylgruppen mit 1 bis 5 C-Atomen substituiert sein. Bevorzugt sind organische chromophore Bisazide, besonders solche ohne Imidgruppen. Hierbei kann es sich um Bisazide der Formel XI

$N_3$ - D - $N_3$ (XI)

handeln, worin D Arylen, wie Phenylen, Naphthylen, Toluylen oder Perylen, bedeutet.

Besonders bevorzugt sind Bisazide der Formel XII

$N_3$—E-(Y)q-E—$N_3$ (XII),

worin E für einen aromatischen Kohlenwasserstoffrest, besonders für Phenylen, und q für O oder 1 stehen und Y eine anorganische oder organische Gruppe ist, die zusammen mit den aromatischen Kohlenwasserstoffresten E ein mesomeres System bildet. Bevorzugt ist Y O, CO, S, SO, $SO_2$, NR' (R' gleich Wasserstoff, Alkyl, Cycloalkyl, Aryl oder Aralkyl),

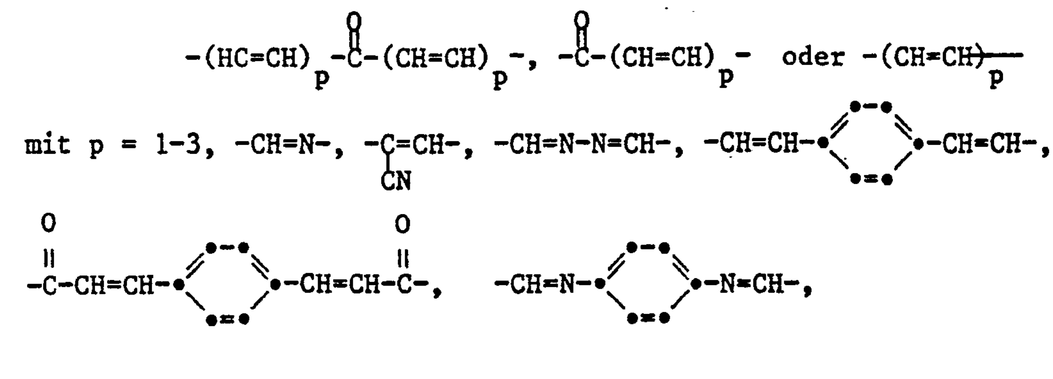

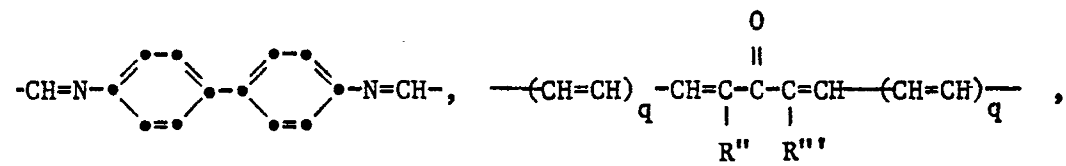

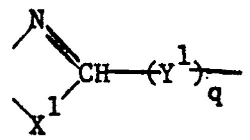

oder

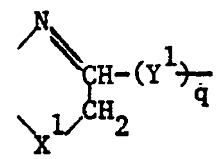

,

worin R" und R''' unabhängig voneinander Alkyl mit 1 bis 5 C-Atomen oder R" und R''' zusammen unsubstituiertes oder mit Alkyl, Hydroxyalkyl, Alkoxy, Trialkylsilyl, Hydroxy, Carboxyl, Alkoxycarbonyl, Amino, Alkylamino oder Dialkylamino substituiertes Aethylen oder Trimethylen bedeuten, q O oder 1 ist, $X^1$ für O, S oder NH steht, $Y^1$ unabhängig die gleiche Bedeutung wie Y hat und die freien Bindungen an N und $X^1$ zusammen mit der Gruppe E einen kondensierten heterocyclischen Ring bilden. Bevorzugt ist $Y^1$ eine direkte Bindung oder -CH = CH-.

R' enthält als Alkyl bevorzugt 1 bis 6 C-Atome, als Cycloalkyl bevorzugt 5 oder 6 Ringkohlenstoffatome, als Aryl bevorzugt 6 bis 12 C-Atome und als Aralkyl bevorzugt 7 bis 14 C-Atome. Als Substituent für die Aethylen- oder Trimethylengruppe kommt bevorzugt Alkyl mit 1-6 C-Atomen, besonders Methyl oder Aethyl, Hydroxyalkyl mit 1 bis 6 C-Atomen, besonders Hydroxymethyl, Alkoxy mit 1 bis 6 C-Atomen, besonders Methoxy oder Aethoxy, Alkoxycarbonyl mit 2 bis 12, besonders 2 bis 6 C-Atomen, wie Methoxy- oder Aethoxycarbonyl oder Alkylamino oder Dialkylamino mit 1 bis 6 C-Atomen in der Alkylgruppe, wie Dimethylamino, sowie Trialkylsilyl mit 1 bis 6 C-Atomen in den Alkylgruppen, wie Trimethylsilyl, in Frage.

Eine bevorzugte Untergruppe sind Bisazide der Formel XIII

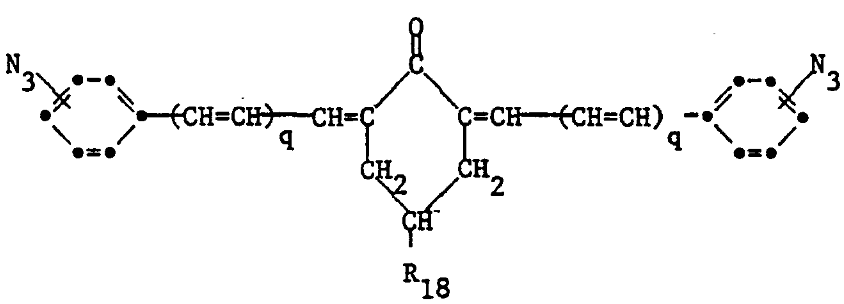

(XIII),

worin die Azidogruppen bevorzugt in p-Stellung gebunden sind, q O oder 1 ist und $R_{18}$ OH, COOH, $NH_2$, Alkyl, Hydroxyalkyl, Alkoxycarbonyl, Trialkylsilyl, Alkylamino oder Dialkylamino bedeutet. Für $R_{18}$ in der

Bedeutung von Alkyl, Hydroxyalkyl, Alkoxycarbonyl, Trialkylsilyl, Alkylamino und Dialkylamino gelten die zuvor unter R" und R''' aufgeführten Bevorzugungen.

Beispiele für geeignete Polyazide sind:

Bisazidobenzol, Bisazidonaphthalin, Bisazidotoluol, p-Bisazidobiphenylen, 4,4'-Bisazido-2,2'-dimethylbiphenylen, 4,4'-Bisazido-diphenyläther, 4,4'-Bisazido-diphenylketon, 4,4'-Bisazido-diphenylsulfon, 3,3'-Bisazidodiphenylsulfid, 4,4'-Bisazidodiphenylamin, 1,2-Bis-(4-azidophenyl)äthylen, 1-Cyanol-1,2-bis-(-4-azidophenyl)-äthylen, 4-Azidophenyl-(4-azidophenylvinyl)keton, Bis-(4-azidophenylvinyl)keton, 1,4-Bis-(4-azidophenyl)-butadien und solche der Formeln

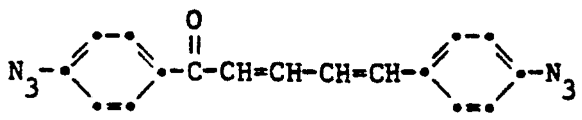 , 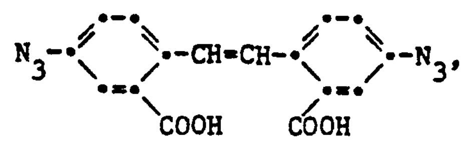,

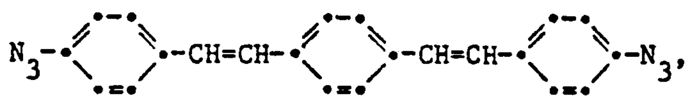,

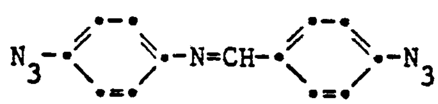, 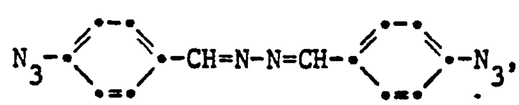,

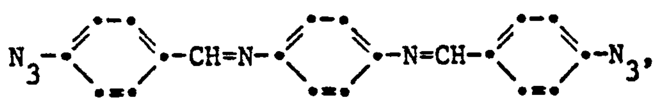,

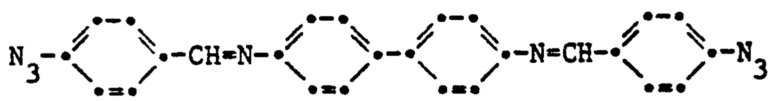,

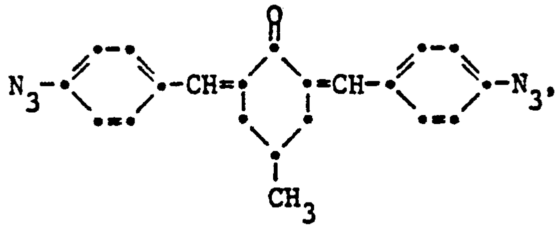,

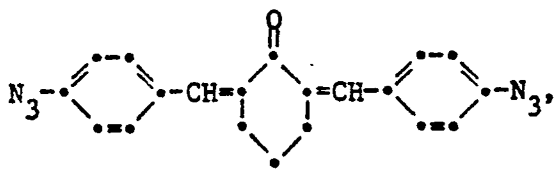, 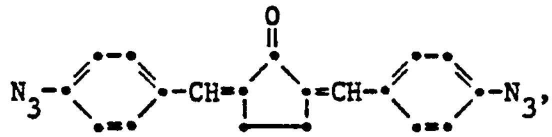,

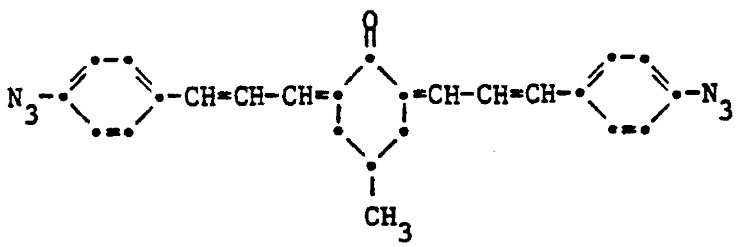,

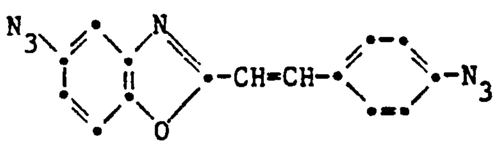, 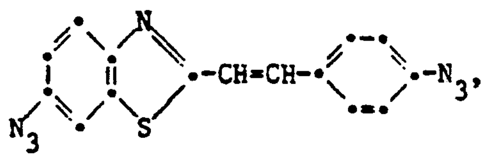,

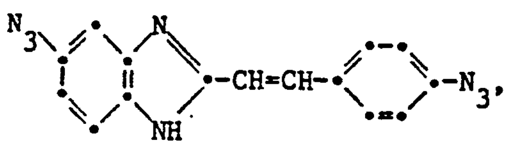, 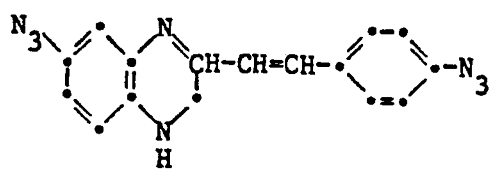

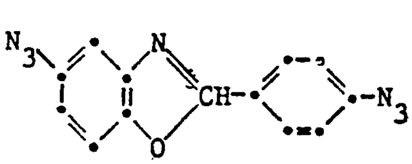, 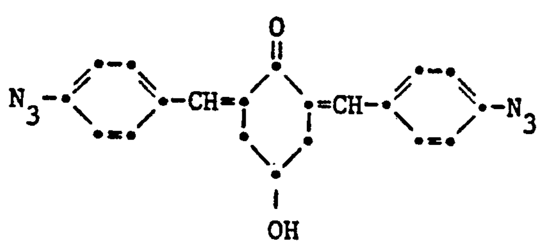,

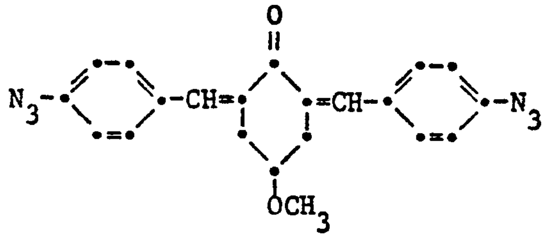,

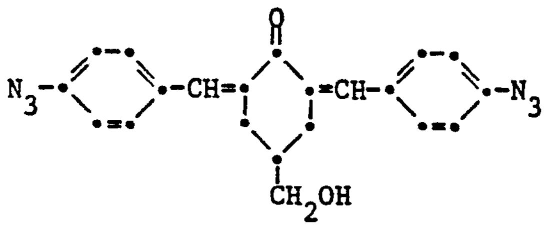,

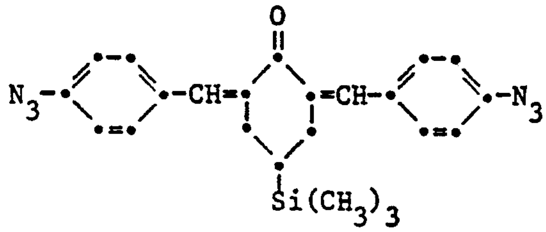,

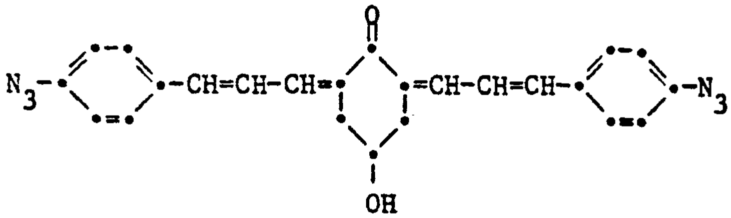,

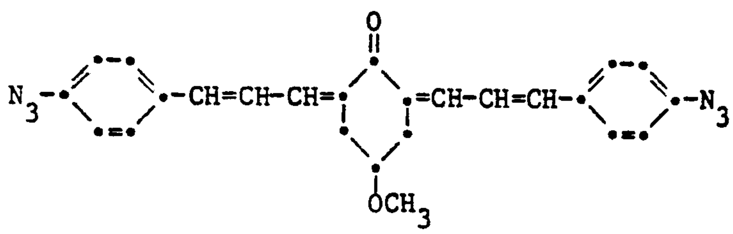,

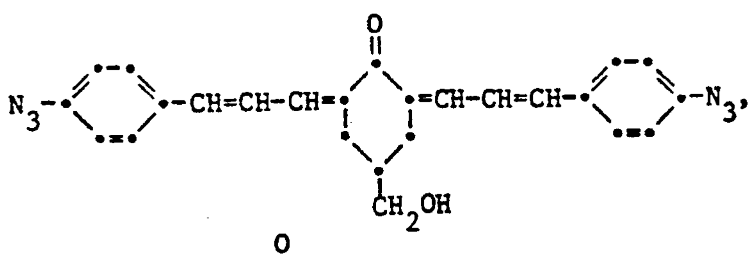,

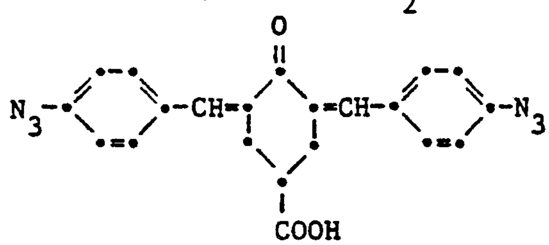,

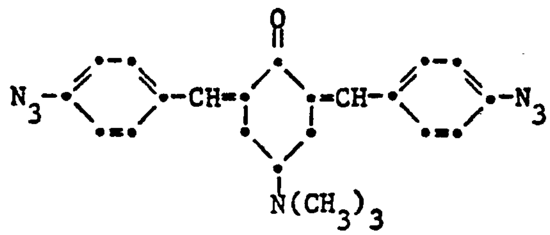

und

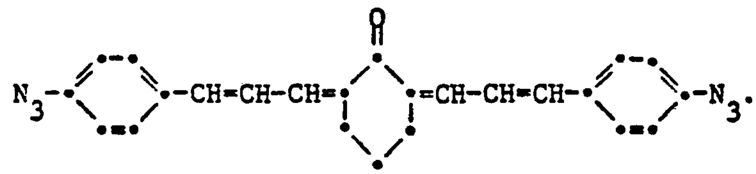

Als Beispiele von Polyaziden, in denen die Azidgruppe über eine $SO_2$-Gruppe an aromatische Kohlenstoffreste gebunden sind, seien die Verbindungen der folgenden Formeln erwähnt:

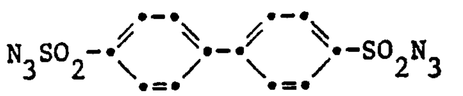

,

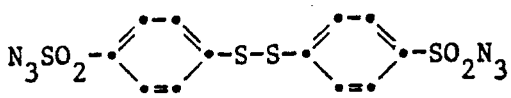

und

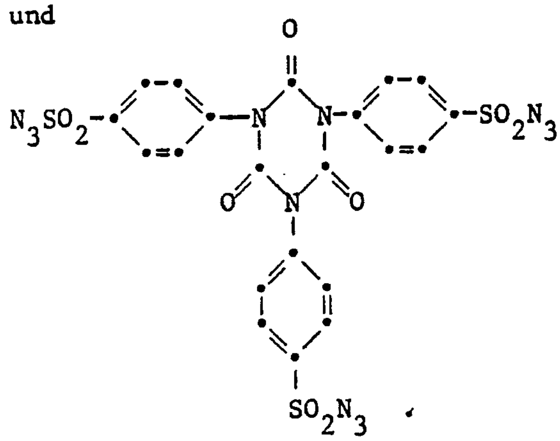

Die Verwendung von Polyaziden mit direkter Bindung der Azidgruppen an aromatische Kohlenwasserstoffreste ist bevorzugt.

Besonders bevorzugt ist das 2,6-Bis(4-azidobenzyliden)-4-methylcyclohexan-1-on.

Gegenstand der Erfindung ist auch ein strahlungsempfindliches Beschichtungsmittel, enthaltend neben üblichen Zusätzen (a) ein organisches Lösungsmittel, (b) ein in diesem Lösungsmittel lösliches Homo- oder Copolyimid, das dadurch erhältlich ist, dass man ein Anhydrid der Formel E

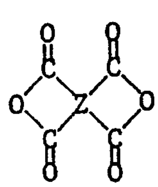

(E)

oder ein Gemisch verschiedener Anhydride der Formel E mit 50 bis 100 Mol.% eines Diamins der Formel F

oder G

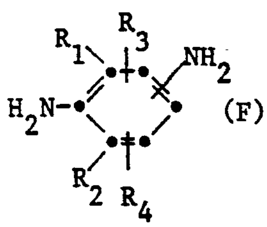 (F) oder 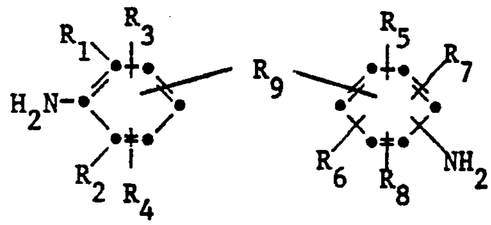 (G)

oder eines Gemisches aus diesen Diaminen und mit 50 bis O Mol.% eines Diamins der Formel H

$H_2N - Z' - NH_2$ (H)

umsetzt, und die erhaltene Polyamidsäure cyclisiert, und (c) mindestens 0,1 Gew.%, bezogen auf die Komponente (b), mindestens eines organischen chromophoren Polyazids, in dem die Azidgruppen direkt oder über eine $SO_2$-Gruppe an aromatische Kohlenwasserstoffreste gebunden sind, wobei Z, Z' und $R_1$ bis $R_9$ die oben angegebene Bedeutung haben. Dabei gilt in Bezug auf bevorzugte Bedeutungen dieser Reste, geeignete organische Lösungsmittel (a) und Polyazide (c) das oben Angegebene.

Die Herstellung der erfindungsgemässen Beschichtungsmittel erfolgt im allgemeinen durch Lösen der Komponenten im organischen Lösungsmittel. Zweckmässig geht man so vor, dass zunächst das Polyimid unter Erwärmen vollständig gelöst wird und danach das Polyazid zugemischt wird, gegebenenfalls unter leichtem Erwärmen. Ungelöste Anteile können durch Filtration, bevorzugt einer Druckfiltration, entfernt werden.

Die mengenmässige Zusammensetzung des erfindungsgemässen Beschichtungsmittels richtet sich im wesentlichen nach der gewünschten Applikation. Sie kann 80 bis 99,9, vorzugsweise 85 bis 99,9 und besonders 90 bis 97 Gew.-% Polyimid (b) und 20 bis 0,1, vorzugsweise 15 bis 0,1 und insbesondere 10 bis 3 Gew.-% Polyazid (c) betragen. Dabei sind im Lösungsmittel (a) vorzugsweise nicht mehr als 50 Gew.-%, besonders nicht mehr als 30 Gew.-%, und insbesondere nicht mehr als 20 Gew.-% des Polyimides (b) und Polyazides (c) gelöst sind, bezogen auf die Lösung.

Die Photostrukturierung bzw. Photovernetzung kann durch energiereiche Strahlung hervorgerufen werden, z.B. durch Licht im Bereich von 600-200 nm, durch Röntgenstrahlen, Laserlicht, Elektronenstrahlen usw. und insbesondere durch Licht im Bereich von 450-300 nm.

Den Beschichtungsmitteln können übliche Zusatzmittel einverleibt werden, die die Lichtempfindlichkeit nicht negativ beeinflussen. Beispiele hierfür sind Sensibilisatoren, Mattierungsmittel, Verlaufmittel, feinteilige Füllstoffe, Flammschutzmittel, optische Aufheller, Antioxidantien, Stabilisatoren, Farbstoffe, Pigmente und Haftvermittler.

Ferner können Verbindungen zugegeben werden, welche die Empfindlichkeit von aromatischen Polyaziden erhöhen können. Bevorzugte Verbindungen dieser Art sind z.B. in Photographic Science and Engineering, Vol. 17, Number 4, S. 390 ff (1973) beschrieben. Beispiele sind Anthron, 1,9-Benzanthron, Acridin, Cyanoacridin, Nitropyren, 1,8-Dinitropyren, Michler's Keton, 5-Nitroacenaphthen,2-Nitrofluorenon, 1,2-Benzantrachinon, 2-Chloro-1,8-phthaloylnaphthalin. Solche Verbindungen können alleine oder in Mischung verwendet werden. Als Zusätze können auch Farbstoffe beigegeben werden, die den negativen Einfluss von reflektiertem Streulicht auf das Auflösungsvermögen vermindern können (anti-halation agents). Solche Verbindungen sind z.B. in der US-PS 4.349.619 beschrieben.

Das erfindungsgemässe lichtempfindliche Beschichtungsmittel ist eine viskose Flüssigkeit, die eine hohe Lagerstabilität aufweist, aber vor Licht- und Wärmeeinfluss geschützt werden muss. Es eignet sich besonders für die Herstellung von Isolier- und Schutzlacken, besonders in der Elektrotechnik und Elektronik sowie als photographisches Aufzeichnungsmaterial, z.B. zur Herstellung von Photomasken für die Elektronik, den Textildruck und das graphische Gewerbe.

Die lichtempfindliche Schicht kann mittels üblicher Methoden, wie Tauch-, Streich- und Sprühverfahren, Schleuder-, Kaskadenguss- und Vorhanggussbeschichtung, auf geeignete Substrate bzw. Trägermaterialien, aufgebracht werden. Geeignete Substrate sind z.B. Kunststoffe, Metall und Metallegierungen, Halbmetalle, Halbleiter, wie Si, Ge, GaAs, Glas, Keramik und andere anorganische Materialien, wie z.B. $SiO_2$ und $Si_3N_4$. Danach wird das Lösungsmittel durch Erwärmen, gegebenenfalls im Vakuum entfernt. Man erhält klebfreie, trockene und gleichmässige Filme. Die aufgebrachten Filme mit Schichtdicken bis zu ca. 15 $\mu$m, bevorzugt

bis 5 µm und besonders bis 2 µm werden dann durch Belichtung vernetzt und danach gegebenenfalls durch Tempern vollständig ausgehärtet. Man erhält so Schutzfilme mit hervorragender Haftung und hoher thermischer, mechanischer und chemischer Beständigkeit für z.B. integrierte Schaltkreise.

Die Photovernetzung mit Bisaziden wird bekanntlich durch Luftsauerstoff gehemmt, besonders in dünnen Schichten. Dieser Effekt kann mittels üblicher Methoden vermieden werden, wie Aufbringen einer temporären Schutzschicht aus z.B. Polyvinylalkohol, durch Arbeiten unter Inertgas oder durch Ansaugen der Photomaske mittels Vakuum. Ferner kann man Verbindungen beigeben, die den Einfluss des Sauerstoffs zurückdrängen. Solche Verbindungen sind z.B. in der US-PS 3.479.185 beschrieben.

Das erfindungsgemässe Beschichtungsmittel eignet sich auch hervorragend zur Herstellung eines photographischen Aufzeichnungsmaterials für Reliefabbildungen. Ein weiterer Gegenstand vorliegender Erfindung ist ein solches Aufzeichnungsmaterial enthaltend einen Träger bzw. ein Substrat, auf dem als lichtempfindliche Schicht eine Mischung des Polyimides (b) und des Bisazides (c) aufgebracht ist. Die Dicke der lichtempfindlichen Schicht kann bis 15 µm, besonders bis 5 µm und insbesondere bis 2 µm betragen.

In dem photographischen Aufzeichnungsmaterial kann die lichtempfindliche Schicht z.B. als Aetzresist zur Herstellung gedruckter Schaltungen und Druckplatten und integrierter Schaltkreise, als Lötstopplack, als Passivierschicht, als Dielektrikum für Mehrlagenschaltungen, als Strukturelement für Flüssigkristallanzeiger oder als Filtermaterial für Photosensoren verwendet werden.

Bevorzugte Anwendungen sind das Aufbringen von Isolier- und Schutzlacken und vor allem die Herstellung von gedruckten Schaltungen, diskreten Halbleiterbauelementen und von integrierten Schaltkreisen.

Die photographische Erzeugung der Reliefstruktur erfolgt durch bildmässige Belichtung mittels einer Photomaske, anschliessende Entwicklung unter Entfernung der unbelichteten Anteile mit einem Lösungsmittel oder einem Lösungsmittelgemisch, wonach das erzeugte Bild gegebenenfalls durch eine thermische Nachbehandlung stabilisiert werden kann.

Das erfindungsgemässe Beschichtungsmittel weist verschiedene weitere Vorteile auf. Die nachträgliche Imidbildung in den bekannten lichtempfindlichen Kompositionen wird vermieden. Man erhält auf Grund der guten Filmbildungseigenschaften gleichmässige Beschichtungen, die nach der Belichtung und termischen Nachbehandlung praktisch keinen Schichtdickenschwund aufweisen. Ferner sind die Lösungen lagerstabil und die erzeugten Bilder weisen auf den Substraten eine hohe Haftfestigkeit auf. Die mit dem erfindungsgemässen Beschichtungsmitteln erhaltenen Reliefstrukturen zeichnen sich ferner durch eine hohe thermische Beständigkeit unter Luftausschluss aus.

Die nachfolgenden Beispiele erläutern die Erfindung näher.

A) Herstellung der Polyimide

Die Polyimide werden durch Umsetzung der entsprechenden Dianhydride und Diamine in N-Methylpyrrolidon (NMP) und durch anschliessende Imidisierung der erhaltenen Polyamidsäuren mit Acetanhydrid hergestellt.

Zur Charakterisierung der Polymeren dienen die inhärente Viskosität ($\eta_{\text{inh.}}$) 0,5%iger Lösungen in NMP bei 25 °C und die mittleren Molekulargewichte ($\overline{M}_w$), die mittels Messung der Lichtstreuung bestimmt werden.

Für die Bestimmung des mittleren Molekulargewichts durch Lichtstreuung wird ein Lichtstreugerät KMX-6 der Firma Chromatix verwendet, wobei die Anregung mit Laserlicht von 632,8 nm erfolgt und die Vorwärtsstreuung im Winkelbereich 6-7° gemessen wird.

Herstellungsbeispiel 1:

In einem zylindrischen Gefäss, das mit Rührer, Tropftrichter, Innenthermometer und Stickstoffeinleitungsrohr ausgestattet ist, werden unter Stickstoff 10,16 g (0,04 Mol) 4,4'-Diamino-3,3',5,5'-tetramethyldiphenylmethan in 130 ml N-Methyl-2-pyrrolidon (NMP) gelöst und auf 0 bis 5 °C abgekühlt. Nun werden je 0,02 Mol 3,3',4,4'-Benzophenontetracarbonsäuredianhydrid (BTDA) und Pyromellitsäuredianhydrid (PMDA) bereitgestellt und in Portionen im Verlaufe von 4 Stunden zugesetzt. 30 Minuten nach dem letzten Zusatz werden 8,9 g (0,09 Mol) Triäthylamin und 36,7 g (0,36 Mol) Acetanhydrid zugetropft, um die entstandene Polyamidsäure zum Polyimid zu cyclisieren. Nach 16 Stunden Rühren bei Raumtemperatur wird die Lösung unter starkem Rühren auf 2 Liter Wasser gegossen, und das ausgefallene Produkt wird abfiltriert. Das Produkt wird erneut mit 2 Liter Wasser behandelt, filtriert und bei 80 °C im Vakuum getrocknet. Die inhärente Viskosität, gemessen als 0,5%ige Lösung in NMP bei 25 °C beträgt 0,75 dl/g. Die Glasumwand-

lungstemperatur (Tg), gemessen durch Differential-Scanning-Calometrie (DSC) beträgt 403 °C; mittleres Molekulargewicht $\overline{M}_w$ = 38'000.

Herstellungsbeispiel 2:

Es wird wie in Beispiel 1 verfahren, unter Verwendung von 0,04 Mol 3,3',4,4'-Benzophenontetracarbonsäuredianhydrid und 0,04 Mol 1,4-Diamino-2,3,4,5-tetramethylbenzol. Eigenschaften des erhaltenen Polyimids: $\eta_{inh.}$ = 0,92 dl/g; Tg = 439 °C; mittleres Molekulargewicht $\overline{M}_w$ = 42'000.

Herstellungsbeispiel 3:

5 g des gemäss Herstellungsbeispiel 2 erhaltenen Polymeren werden in 100 g 4-Butyrolacton gelöst und unter Zutropfen von Toluol einer Fraktionierung unterzogen. Im Bereich der Verhältnisse Toluol : 4-Butyrolacton von 1,00 bis 1,10 werden 1,2 g einer Polymerfraktion mit $\eta_{inh.}$ = 1,42 dl/g und einem mittleren Molekulargewicht $\overline{M}_w$ von 155'000 isoliert.

Herstellungsbeispiel 4-7:

Nach dem in den Beispielen 1 und 2 beschriebenen Verfahren werden verschiedene Diamingemische mit einer äquivalenten Menge BTDA umgesetzt, anschliessend zum Polyimid cyclisiert und das Polyimid gegebenenfalls entsprechend Herstellungsbeispiel 3 einer Fraktionierung unterzogen.

Die verwendeten Diamine und die Eigenschaften der erhaltenen Polyimide sind in der folgenden Tabelle 1 angegeben.

Tabelle 1

| Beispiel Nr. | Diamin 1 | Mol. % | Diamin 2 | Mol. % | $\eta$ inh. dl/g | Tg (°C) |
|---|---|---|---|---|---|---|
| 4 | 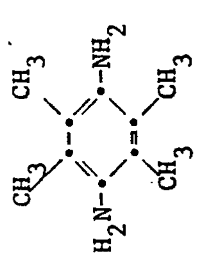 | 50 | 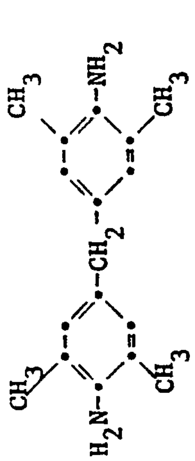 | 50 | 0,76 | 377 |
| 5 | 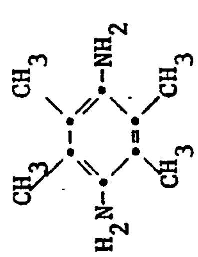 | 50 | 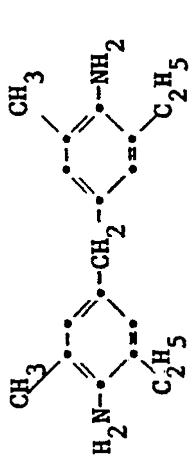 | 50 | 0,78 | 364 |
| 6 | 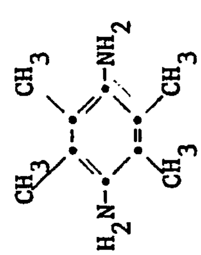 | 70 | 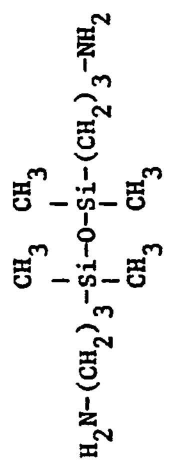 | 30 | 0,71 | 276 |
| 7 | 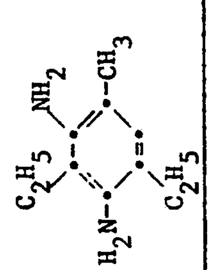 | 90 | 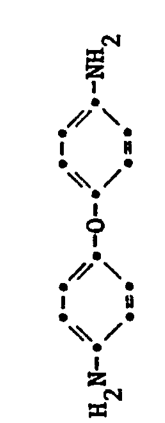 | 10 | 0,78* | 388 |

* fraktioniert

B) Anwendungsbeispiele

In den folgenden Anwendungsbeispielen dienen als Substrate 3-Zoll Siliziumwafer mit einer Beschichtung von 0,1 μm $SiO_2$. Belichtet wird mit einer Maskenjustier- und Belichtungsmaschine der Firma Karl

Süss, wobei die Lichtleistung mit Hilfe eines Intensitätsmessgerätes der Firma Optical Associates Inc. bestimmt wird. Die Angaben beziehen sich auf die Sonde von 365 nm. Zur Anwendung kommt eine Schwarzchrommaske, die Testmuster aller in der Halbleiterfertigung üblichen geometrischen Formen enthält, und zwar in der Grösse 1 µm, 2 µm, 3 µm.... 10 µm, 20 µm .... 100 µm. Obwohl auch bei Belichtungszeiten wesentlich tiefer als im folgenden angegeben scharfe Bildstrukturen erzeugt werden können, sind hier nur diejenigen Zeiten angegeben, bei denen eine exakte 1:1 Abbildung aller geometrischen Figuren gleich oder grösser dem 4-fachen der Schichtdicke beobachtet wird (Gleichheit von Gräben und Stegen).

Entwickelt wird in einem Sprühentwickler bei 2 bar Druck und Umdrehungszahlen zwischen 500 und 2000 U/min, wobei Entwicklungszeiten zwischen 6 und 35 sec nötig sind. Ein Profilometer der Firma Tencor (Alpha-Step) dient zur Bestimmung der Schichtdicken.

Bei der Beurteilung von Belichtungsenergie und Auflösung kommen Kriterien zur Anwendung, die z.B. den in L.F. Thompson, G.G. Willson, N.J. Bowden, "Introduction to Microlithography, ACS Symposium Series 219, Washington DC, 1983, S. 162-172, gegebenen Kriterien entsprechen. Zur Messung der elektrischen Eigenschaften der genannten Beschichtungen werden die beschriebenen photoempfindlichen Mischungen bei einem Feststoffgehalt von 8-20 Gew.% zu 20 µm starken Schichten auf Aluminiumsubstrate aufgeschleudert und belichtet. Nach der entsprechenden thermischen Belastung im Temperofen unter Inertgasatmosphäre (z.B. $N_2$, 2 h, 400 ± 2 °C) und nach dem Abkühlen werden die Proben oberflächlich mit Leitsilber versehen, bei 110 °C während 30 min vorkonditioniert und dann mit Hilfe eines L-8 Megohm-Meters der Fa. Beckmann Instruments Inc. bei Raumtemperatur vermessen.

Beispiel I:

Aus einem Polyimid, erhalten gemäss Herstellungsbeispiel 1, wird eine 9,0%ige Lösung in 4-Butyrolacton hergestellt, der, bezogen auf das Polymere, 7 Gew.% des Bisazids 2,6-Bis-(4-azidobenzyliden)-4-methylcyclohexan-1-on beigemischt werden.

Nach der Filtration durch ein 0,45 µm Filter schleudert man die Lösung bei 3400 U/min auf mit $SiO_2$ beschichtete 3-Zoll-Wafer auf und trocknet 10 min lang bei 60 °C im Umluftofen. Belichtet wird durch eine Schwarzchrommaske im Vakuumkontakt bei gleichzeitiger $N_2$-Begasung. Es wird wie folgt im Sprühentwickler entwickelt:

| | |
|---|---|
| Toluol/4-Butyrolacton (2,40 : 1,00 Masse) | 8 sec |
| Toluol/4-Butyrolacton (5,80 : 1,00 Masse) | 2 sec |
| Toluol | 3 sec. |

Bei einer Belichtungsenergie vom 850 mJ/cm² entsteht ein getreues Bild der Maske, wobei auch die Stege und Gräben der Dimension 2 µm noch gut aufgelöst sind. Die Höhe der Reliefstrukturen beträgt 0,99 µm.

Die Wafer werden sodann in einen Temperofen gegeben, unter $N_2$-Atmosphäre innerhalb 1 h 20 min auf 400 °C erhitzt, 10 min lang dort belassen und dann abgekühlt. Die Schichtdicke beträgt danach 0,90 µm, und die Reliefstrukturen halten auch einer starken chemischen Belastung, wie Eintauchen in heisses N-Methyl-2-pyrrolidon unter gleichzeitiger Anwendung von Ultraschall, stand. Sodann werden die Reliefstrukturen einer thermischen Belastung ausgesetzt, indem man sie auf 400 °C aufheizt und dann 1 h lang bei Temperaturen zwischen 400 und 450 °C belässt. Nach dem Abkühlen beträgt die Schichtdicke noch 0,89 µm. Unter dem hoch auflösenden Mikroskop sind keinerlei geometrische Veränderungen der Reliefbilder zu erkennen.

Eine 20 µm starke Schicht der oben beschriebenen Zusammensetzung wird 2 h unter $N_2$-Atmosphäre bei 400 °c behandelt. Danach wird ein spezifischer Durchgangswiderstand $\rho_D$ von $2,1x10^{16}$ ohm•cm gemessen.

Beispiel II:

Aus einem Polymeren, erhalten gemäss Herstellungsbeispiel 2, wird eine 6,75%ige Lösung in 4-Butyrolacton hergestellt. Die Lösung wird mit 7%, bezogen auf das Polymere, 2,6-Bis-(4-azidobenzyliden)4-methylcyclohexan-l-on versetzt, durch ein 0,45 µm Filter gefiltert und bei 1900 U/min. auf mit $SiO_2$ beschichtete 3-Zoll-Wafer aufgeschleudert. Nach dem Trocknen im Umluftofen (10 Minuten bei 60 °C) wird

durch eine Chrommaske im Vakuumkontakt und unter zusätzlicher $N_2$-Begasung belichtet. Anschliessend wird im Sprühentwickler nach folgendem Programm entwickelt (2 bar Sprühdruck):

| | |
|---|---|
| Toluol/4-Butyrolacton (1,07: 1,00, Masse) | 9 sec |
| Toluol/4-Butyrolacton (3,00: 1,00, Masse) | 2 sec |
| Toluol | 3 sec. |

Bei einer Belichtungsenergie von 1100 mJ/cm² entsteht ein getreues Abbild der Maske, wobei die Stege und Gräben mit einer Dimension von 2 μm noch gut aufgelöst sind. Die Höhe der Lackreliefstrukturen wird mit einem Profilometer vermessen, wobei sich ein Wert von 1,00 μm ergibt.

Die belackten und photostrukturierten Wafer werden sodann in einen Temperofen gegeben und unter $N_2$-Atmosphäre innerhalb 1 h 20 min auf 400 °C erhitzt und dort 10 min lang belassen. Nach dem Abkühlen beträgt die Schichtdicke noch 0,88 μm, und die Reliefstrukturen können selbst nach 10-minütigem Behandeln in 60 °C heissem N-Methyl-2-pyrrolidon unter gleichzeitiger Anwendung von Ultraschall nicht mehr beschädigt werden. Die Wafer werden anschliessend ein zweites Mal in den Temperofen gegeben, unter $N_2$-Atmosphäre innerhalb 1 h 15 min auf 400 °C erhitzt und dann 1 h lang bei Temperaturen zwischen 400 und 450 °C belassen. Nach dem Abkühlen wird eine Schichtdicke von 0,86 μm gemessen, und bei der optischen Inspektion im hoch auf lösenden Mikroskop sind auch keinerlei geometrische Veränderungen des Reliefmusters zu erkennen.

Eine 20 μm starke Schicht der oben beschriebenen Zusammensetzung wird 2 h unter $N_2$-Atmosphäre bei 400 °C behandelt. Danach wird ein spezifischer Durchgangswiderstand $\rho_D$ von $2{,}4 \times 10^{16}$ ohm•cm gemessen. Auch nach einer 2-stündigen Behandlung bei 450 °C beträgt $\rho_D$ noch $1{,}7 \times 10^{16}$ ohm•cm.

Beispiel III:

Das gemäss Herstellungsbeispiel 3 erhaltene Polymere wird als 0,5%ige Lösung in 4-Butyrolacton mit 6 Gew.-%, bezogen auf das Polymere, des Bisazids 2,6-Bis-(4-azidobenzyliden)-4-methyl-cyclohexan-l-on versetzt. Die Verarbeitung erfolgt analog zu Anwendungsbeispiel II. Entwickelt wird während 35 sec mit einer Mischung aus 4-Butyrolacton und Toluol (Gewichtsverhältnis 1:0,4). Es ist eine Belichtungsenergie von 135 mJ/cm² notwendig, um hoch aufgelöste Strukturen (Auflösung = 2 μm) bei 1,07 μm Schichtstärke zu erzeugen, wobei die Maske dimensionsgetreu abgebildet ist. Die Strukturen werden sodann entsprechend den Anwendungsbeispielen I und II 10 min auf 400 °C erhitzt, wobei sie chemisch völlig inert werden. Die Schichtstärke beträgt dann 0,94 μm. Nach nochmaligem Erhitzen auf 400-450 °C während 1 h beträgt die Schichtstärke 0,92 μm.

Anwendungsbeispiele IV-VII:

Die gemäss den Herstellungsbeispielen 4-7 erhaltenen Polymeren werden in 4-Butyrolacton gelöst und mit jeweils 6 Gew.-%, bezogen auf das Polymere, 2,6-Bis-(4-azidobenzyliden)-4-methylcyclohexan-l-on versetzt, gefiltert und auf Si-Wafer bzw. Aluminiumsubstrate aufgeschleudert. Die Verarbeitungsdaten und die elektrischen Eigenschaften der so hergestellten Schichten sind aus Tabelle 2 ersichtlich.

Tabelle 2

| Polymer Nr. | Entwickler (Gew.-Verhältnis) | Entwicklungszeit (sec) | Schichtstärke 1) ( µm) | Schichtstärke nach 1 h bei 400°C ( µm) | Belichtungsenergie (mJ/cm$^2$) | spez. Durchgangswiderstand ohm•cm 2) | Auflösung ( µm) |
|---|---|---|---|---|---|---|---|
| 4 | NMP:MEK 1:1,52 | 6 | 0,99 | 0,92 | 1200 | $1,3x10^{16}$ | 2 |
| 5 | GBL:Tol 1:2,00 | 11 | 1,08 | 0,98 | 560 | $1,4x10^{16}$ | 2 |
| 6 | GBL:Tol 1:2,00 | 15 | 1,52 | 1,37 | 560 | $1,1x10^{16}$ | 3 |
| 7 | GBL:Tol 1:1,80 | 12 | 1,01 | 0,90 | 610 | $1,3x10^{16}$ | 2 |

NMP = N-Methyl-2-pyrrolidon
MEK = Methyläthylketon
GBL = 4-Butyrolacton
Tol = Toluol

1) nach dem Entwickeln
2) nach 2 h bei 400°C in $N_2$-Atmosphäre gemäss DIN 53482, auf Aluminiumsubstrat

## Patentansprüche

1. Strahlungsempfindliches Beschichtungsmittel, enthaltend (a) ein organisches Lösungsmittel, (b) ein in diesem Lösungsmittel lösliches Homo- oder Copolyimid, das im wesentlichen aus 50 bis 100 Mol %

wiederkehrenden Strukturelementen der Formeln Ia und/oder Ib

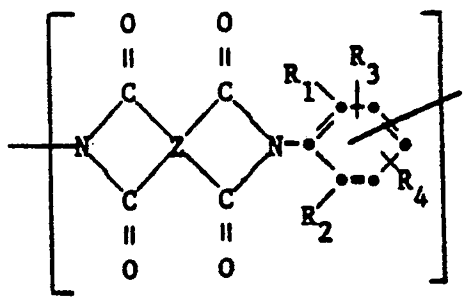

(Ia) und/oder

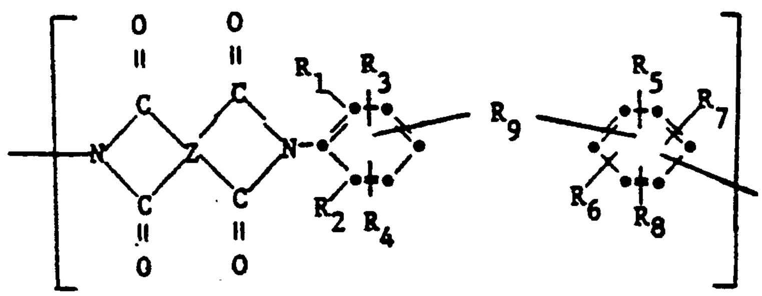

(Ib)

und 50 bis 0 Mol.% wiederkehrenden Strukturelementen der Formel II

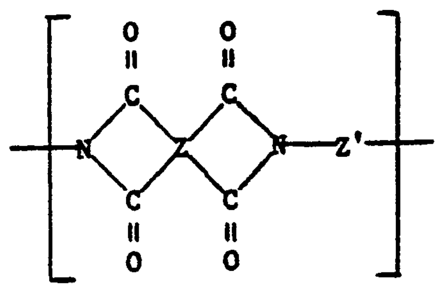

(II)

besteht, und (c) mindestens 0,1 Gew.%, bezogen auf die Komponente (b), mindestens eines organischen chromophoren Polyazids, in dem die Azidgruppen direkt oder über eine $SO_2$-Gruppe an aromatische Kohlenwasserstoffreste gebunden sind, wobei in den Formeln Ia, Ib und II die vier Carbonylgruppen an verschiedene Kohlenstoffatome gebunden sind und je zwei Carbonylgruppen in ortho- oder peri-Stellung zueinander stehen, Z einen vierwertigen Rest bedeutet, der mindestens einen aromatischen Ring enthält,
Z' einen von Gruppen

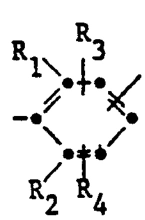

oder

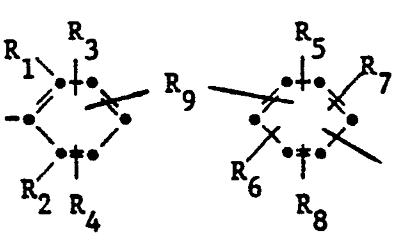

verschiedenen zweiwertigen organischen Rest darstellt, ausgewählt unter aromatischen, alkylaromatischen, aliphatischen, cycloaliphatischen und heterocyclischen Resten, Kombinationen davon und Resten mit Sauerstoff, Schwefel, Stickstoff, Silicium oder Phosphor enthaltenden Brückengruppen,
$R_1$ und $R_2$ unabhängig voneinander Alkyl mit 1-4 C-Atomen,
$R_3$, $R_4$, $R_5$, $R_6$, $R_7$ und $R_8$ unabhängig voneinander Wasserstoff oder Alkyl mit 1-4 C-Atomen und
$R_9$ die direkte Bindung, -O-, -S-, -SO-, -S-S-, $SO_2$-, -CO-, -COO-, -NH-,

$$-\overset{|}{N}-\text{Alkyl}$$

mit 1-6 C-Atomen im Alkyl,

$$-\overset{|}{N}-\text{Phenyl},$$

$$-\overset{|}{N}-\text{Benzyl},$$

-CONH-,

$$-CO\overset{|}{N}-\text{Alkyl}$$

mit 1-6 C-Atomen im Alkyl,

$$-CO\overset{|}{N}-\text{Phenyl},\ -CO\overset{|}{N}-\text{Benzyl},$$

eine lineare oder verzweigte Alkylengruppe mit 1-3 C-Atomen, Alkyliden mit 2-12 C-Atomen, Cycloalkyliden mit 5-6 Ringkohlenstoffatomen, Phenylen,

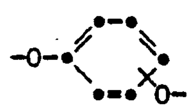

oder eine Gruppe

$$R_{10}\overset{|}{\underset{|}{Si}}-R_{11}$$

bedeuten, worin $R_{10}$ und $R_{11}$ Alkyl oder Alkoxy mit je 1-6 C-Atomen, Phenyl, Benzyl, Phenyloxy oder Benzyloxy darstellen.

**2.** Strahlungsempfindliches Beschichtungsmittel nach Anspruch 1, worin die Azidgruppen des chromophoren Polyazids direkt an aromatische Kohlenwasserstoffreste gebunden sind.

**3.** Stahlungsempfindliches Beschichtungsmittel nach Anspruch 1, worin Z einer oder mehreren der Strukturen

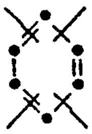, 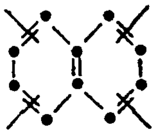, 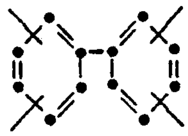, 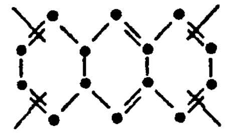,

(1) (2) (3) (4)

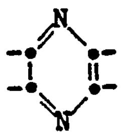, 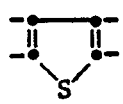, 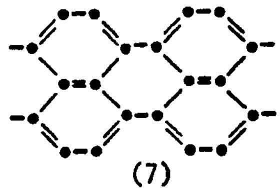, 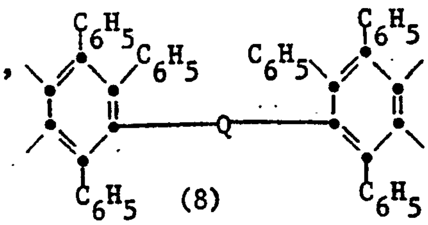,

(5) (6) (7) (8)

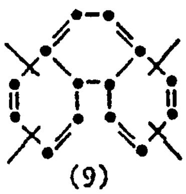 oder 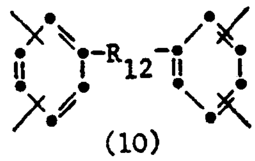 entspricht,

(9) (10)

worin Q 1,3- oder 1,4-Phenylen oder einen Diphenylätherrest darstellt und $R_{12}$ ausgewählt ist aus der Gruppe, bestehend aus

-O-, -S-, $-SO_2-$, 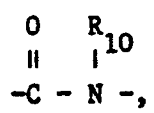, 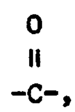, 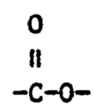, 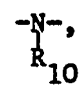, 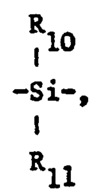,

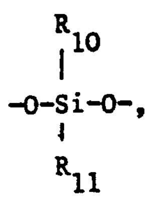, 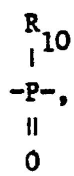, 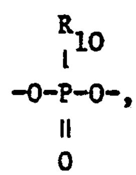, -N=N-, 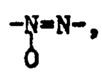, -NH-, 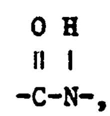, $-CH_2-$,

$-CH_2-CH_2-$, 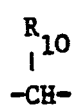 und 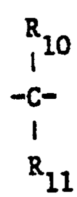,

wobei $R_{10}$ und $R_{11}$ die im Anspruch 1 angegebene Bedeutung haben.

4. Strahlungsempfindliches Beschichtungsmittel nach Anspruch 1, worin Z der Rest des Pyromellitsäuredianhydrids, ein Rest der Formel VI

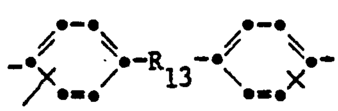 (VI)

oder ein Gemisch dieser Reste ist, worin $R_{13}$ die direkte Bindung, $-CH_2-$, -O- oder $-SO_2-$ oder -CO- ist.

5. Strahlungsempfindliches Beschichtungsmittel nach Anspruch 1, worin Z der Rest des Pyromellitsäuredianhydrids, ein Rest der Formel VIa

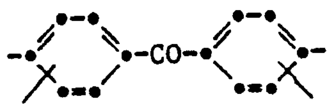 (VIa)

oder ein Gemisch dieser Reste ist.

6. Strahlungsempfindliches Beschichtungsmittel nach Anspruch 1, worin $R_1$ und $R_2$ unabhängig voneinander Methyl oder Aethyl, $R_3$ bis $R_8$ unabhängig voneinander Wasserstoff, Methyl oder Aethyl und $R_9$ -$CH_2$-, -O-, -CO- oder die direkte Bindung darstellen.

7. Strahlungsempfindliches Beschichtungsmittel nach Anspruch 1, worin $R_1$ und $R_2$ je Aethyl und insbesondere je Methyl und $R_3$ und $R_4$ unabhängig voneinander Wasserstoff oder Methyl bedeuten, wobei sich die freie Bindung in meta- oder insbesondere in para-Stellung zum N-Atom befindet.

8. Strahlungsempfindliches Beschichtungsmittel nach Anspruch 1, worin sich die Strukturelemente der Formel Ia von Diaminen der Formeln A, B, C oder D

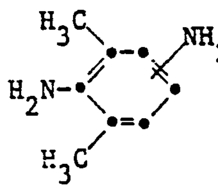 (A), 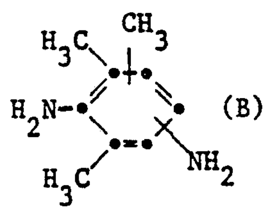 (B) ,

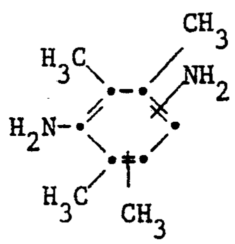 (C) oder 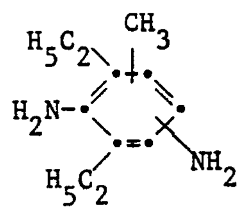 (D)

oder Gemischen davon ableiten, wobei sich die Aminogruppen in meta-und vor allem in para-Stellung zueinander befinden.

9. Strahlungsempfindliches Beschichtungsmittel nach Anspruch 1, worin sich die Strukturelemente der Formeln Ib von symmetrischen Diaminen der Formel III

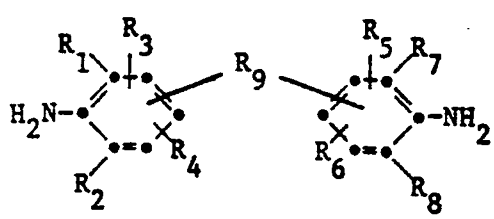 (III)

ableiten, worin $R_9$ die im Anspruch 1 angegebene Bedeutung hat und insbesondere die direkte Bindung, -$CH_2$- oder -CO- darstellt, $R_1$, $R_2$, $R_7$ und $R_8$ je $C_{1-4}$-Alkyl darstellen, $R_3$ und $R_5$ bzw. $R_4$ und $R_6$ dieselbe Bedeutung haben und Wasserstoff oder $C_{1-4}$-Alkyl darstellen.

10. Strahlungsempfindliches Beschichtungsmittel nach Anspruch 1, worin sich die Strukturelemente der Formel Ib von Diaminen der Formel IIIa

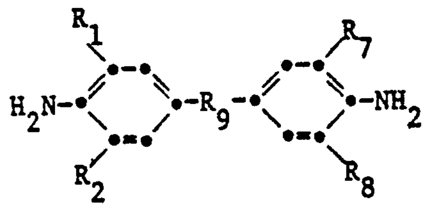

(IIIa)

ableiten, worin $R_1$ und $R_7$ Methyl sind, $R_2$ und $R_8$ Aethyl und vor allem Methyl darstellen und $R_9$ die direkte Bindung, -CO- und insbesondere $-CH_2-$ bedeutet.

**11.** Strahlungsempfindliches Beschichtungsmittel nach Anspruch 1, worin das Homo- oder Copolyimid (b) im wesentlichen aus 70 bis 100 Mol.% wiederkehrenden Strukturelementen der Formel Ia oder Ib oder Gemischen davon und 30 bis 0 Mol.% wiederkehrenden Strukturelementen der Formel II besteht, worin Z der Rest des Pyromellitsäuredianhydrids, ein Rest der Formel VI

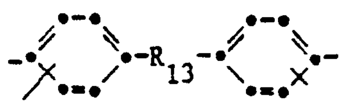

(VI)

oder ein Gemisch dieser Reste ist, $R_1$ und $R_2$ unabhängig voneinander Methyl oder Aethyl, $R_3$ bis $R_8$ unabhängig voneinander Wasserstoff, Methyl oder Aethyl und $R_9$ $-CH_2-$, -O-, -CO oder die direkte Bindung bedeuten, und Z' ein Rest der Formel IX oder X

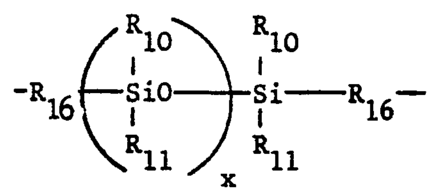

(IX) oder

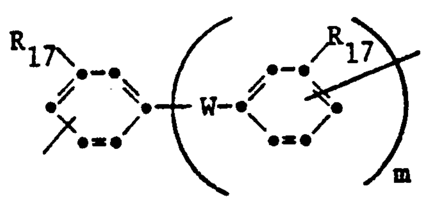

(X)

ist, worin $R_{13}$ die direkte Bindung, $-CH_2-$, -O-, $-SO_2-$ oder -CO- ist, m Null oder 1 darstellt, x eine ganze Zahl von 1-50, $R_{16}$ Alkylen mit 1-6 C-Atomen, $R_{17}$ ein Wasserstoffatom, Alkyl oder Alkoxy mit 1-5 C-Atomen bedeutet, die freien Bindungen in Formel X sich in meta- und bevorzugt in ortho-Stellung zur Gruppe $R_{17}$ befinden, W die direkte Bindung, -S-, -CO-, -NH-,

N-Alkyl

mit 1-5 C-Atomen im Alkyl, -O-, -SO-, -S-S-,

-N-Phenyl,

$-SO_2-$ eine lineare oder verzweigte Alkylengruppe mit 1-3 C-Atomen, Alkyliden mit 2-12 C-Atomen, Cycloalkyliden mit 5 oder 6 Ringkohlenstoffatomen, Phenylen oder eine Gruppe

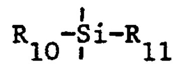

darstellt und $R_{10}$ und $R_{11}$ Alkyl oder Alkoxy mit 1-6 C-Atomen, Phenyl, Benzyl, Phenyloxy oder Benzyloxy bedeuten.

**12.** Strahlungsempfindliches Beschichtungsmittel nach Anspruch 11, worin das Homo- oder Copolyimid (b) im wesentlichen aus 70 bis 100 Mol.% wiederkehrenden Strukturelementen der Formel Ia oder Ib oder Gemischen davon und 30 bis 0 Mol.% wiederkehrenden Strukturelementen der Formel II besteht, worin Z der Rest des Pyromellitsäuredianhydrids, ein Rest der Formel VIa

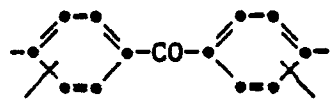 (VIa)

oder ein Gemisch dieser Reste ist, und worin die Strukturelemente der Formel Ia von Diaminen der Formeln A, B, C oder D

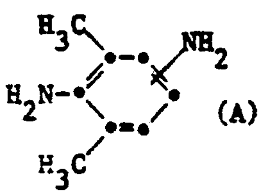 (A), 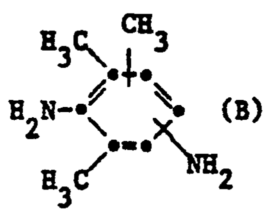 (B),

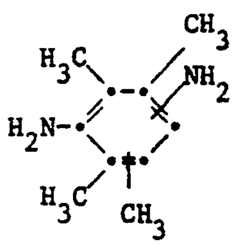 (C) oder 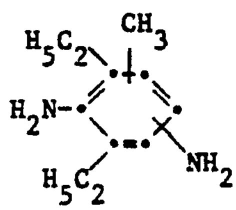 (D)

oder Gemischen davon und die Strukturelemente der Formel Ib von Diaminen der Formel IIIa

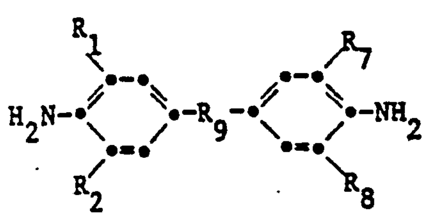 (IIIa)

abgeleitet sind, wobei sich die Aminogruppen in den Formeln A, B, C und D in meta- und vor allem in para-Stellung zueinander befinden, $R_1$ und $R_7$ Methyl sind, $R_2$ und $R_8$ Aethyl und vor allem Methyl darstellen, $R_9$ die direkte Bindung oder -CO- und insbesondere $-CH_2-$ bedeutet und Z' ein Rest der Formel X ist , worin m Null oder 1 darstellt, W die direkte Bindung,-CO- oder $-CH_2-$ und insbesondere -O- und $R_{17}$ ein Wasserstoffatom darstellen.

**13.** Strahlungsempfindliches Beschichtungsmaterial nach Anspruch 11, worin das Homo- oder Copolyimid (b) im wesentlichen aus 70 bis 100 Mol.% wiederkehrenden Strukturelementen der Formel Ia oder 1b oder Gemischen davon und 30 bis 0 Mol.% wiederkehrenden Strukturelementen der Formel II besteht,

worin Z der Rest des Pyromellitsäuredianhydrids, ein Rest der Formel VIa

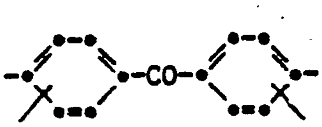

(VIa)

oder ein Gemisch dieser Resteist, und worin die Strukturelemente der Formel Ia von Diaminen der Formeln A, B, C oder D

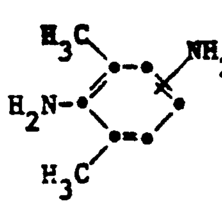

(A),

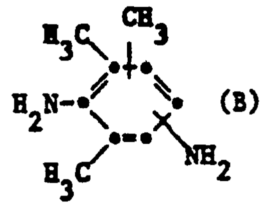

(B) ,

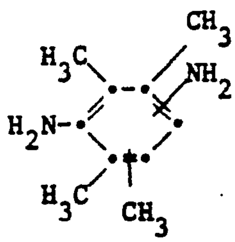

(C) oder

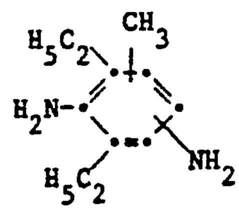

(D)

oder Gemischen davon und die Strukturelemente der Formel Ib von Diaminen der Formel IIIa

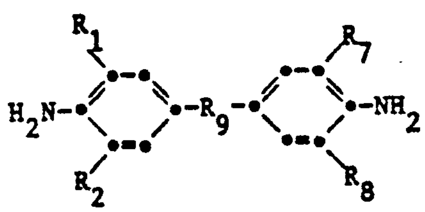

(IIIa)

abgeleitet sind, wobei sich die Aminogruppen in den Formeln A, B, C und D in meta- und vor allem in para-Stellung zueinander befinden, $R_1$ und $R_7$ Methyl sind, $R_2$ und $R_8$ Aethyl und vor allem Methyl darstellen, $R_9$ die direkte Bindung oder -CO- und insbesondere $-CH_2-$ bedeutet und Z' ein Rest der Formel IX ist, worin x die Zahl 1 ist, die $R_{10}$ und $R_{11}$je Methyl und $R_{16}$ Alkylen mit 1-6 und insbesondere 3 C-Atomen darstellen.

**14.** Strahlungsempfindliches Beschichtungsmittel nach Anspruch 11, worin das Homo- oder Copolyimid (b) aus 100 Mol.% wiederkehrenden Strukturelementen der Formel Ia oder Ib oder Gemischen davon besteht, Z der Rest des Pyromellitsäuredianhydrids, ein Rest der Formel VIa

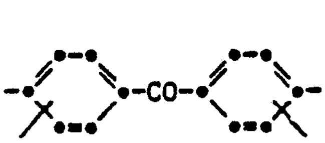

(VIa)

oder ein Gemisch dieser Resteist; und worin die Strukturelemente der Formel Ia von Diaminen der Formeln A, B, C oder D

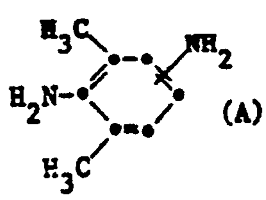

(A),

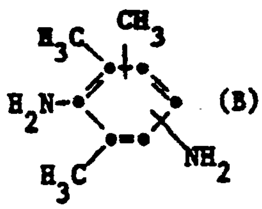

(B) ,

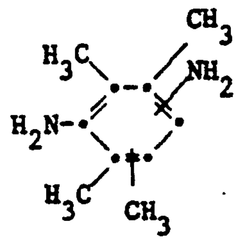

(C) oder

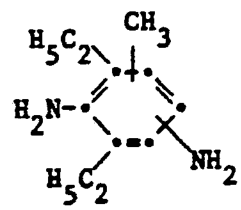

(D)

oder Gemischen davon und die Strukturelemente der Formel Ib von 4,4'-Diamino-3,5,3',5'-tetramethyldiphenylmethan abgeleitet sind.

**15.** Beschichtungsmittel nach Anspruch 1, dadurch gekennzeichnet, dass es 99,9 bis 80 Gew.% des Polyimides (b) und 0,1 bis 20 Gew.% des Polyazides (c) enthält, bezogen auf die Bestandteile (b) und (c).

**16.** Beschichtungsmittel nach Anspruch 1, dadurch gekennzeichnet, dass das Lösungsmittel ein polares aprotisches Lösungsmittel ist.

**17.** Beschichtungsmittel nach Anspruch 1, dadurch gekennzeichnet, dass das chromophore Polyazid ein Bisazid der Formel XII

$N_3$-E-$(Y)_q$-E-$N_3$ (XII)

ist, worin E für einen aromatischen Kohlenwasserstoffrest und q für O oder I stehen und Y eine anorganische oder organische Gruppe ist, die zusammen mit den aromatischen Kohlenwasserstoffresten E ein mesomeres System bildet.

**18.** Beschichtungsmittel nach Anspruch 17, worin Y für
O, CO, S, SO, $SO_2$, NR' mit R' gleich Wasserstoff, Alkyl, Cycloalkyl, Aryl oder Aralkyl,

$$-(HC{\equiv}C)_p-\overset{O}{\overset{\|}{C}}-(CH{=}CH)_p-,\quad -\overset{O}{\overset{\|}{C}}-(CH{=}CH)_p-\ \text{oder}\ -(CH{=}CH)_p-$$

mit p = 1-3,

$-CH{=}N-$, $-\underset{CN}{\underset{|}{C}}{=}CH-$, $-CH{=}N-N{=}CH-$, 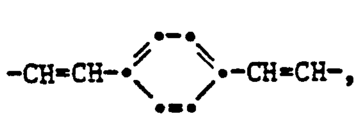

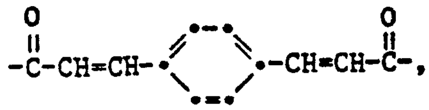, 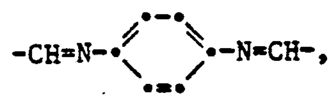,

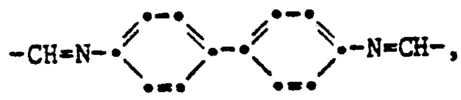, 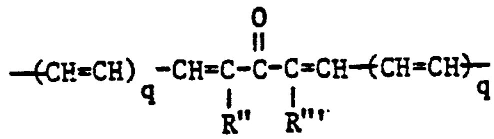,

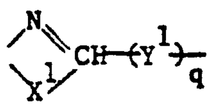 oder 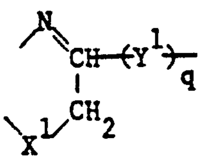,

steht, worin R" und R''' unabhängig voneinander Alkyl mit 1 bis 5 C-Atomen oder R" und R''' zusammen unsubstituiertes oder mit Alkyl, Hydroxyalkyl, Alkoxy, Trialkylsilyl, Hydroxy, Carboxyl, Alkoxycarbonyl, Amino, Alkylamino oder Dialkylamino substituiertes Aethylen oder Trimethylen bedeuten, q O oder 1 ist, $X^1$ für O, S oder NH steht, $Y^1$ unabhängig die gleiche Bedeutung wie Y hat und die freien Bindungen an N und $X^1$ zusammen mit der Gruppe E einen kondensierten heterotyclischen Ring bilden.

**19.** Beschichtungsmittel nach Anspruch 1, dadurch gekennzeichnet, dass das Polyazid 2,6-Bis(4-p-azidobenzyliden)-4-methylcyclohexan-l-on ist.

**20.** Photographisches Aufzeichnungsmaterial für Reliefabbildungen, enthaltend einen Träger, auf dem als strahlungsempfindliche Schicht eine Mischung des Polyimides (b) und Polyazides (c) gemäss Anspruch 1 aufgebracht ist.

**21.** Verwendung von Beschichtungsmitteln gemäss Anspruch 1 zum Aufbringen von Isolier- und Schutzlacken und insbesondere zur Herstellung von gedruckten Schaltungen, diskreten Halbleiterbauelementen und von integrierten Schaltkreisen.

## Claims

**1.** Radiation-sensitive coating agent comprising (a) an organic solvent, (b) a homopolyimide or copolyimide which is soluble in this solvent and which essentially comprises 50 to 100 mol % of recurring structural elements of the formulae Ia and/or Ib

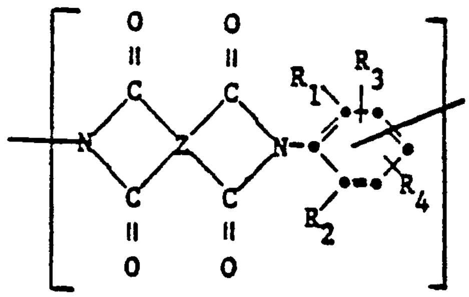

(Ia) and/or

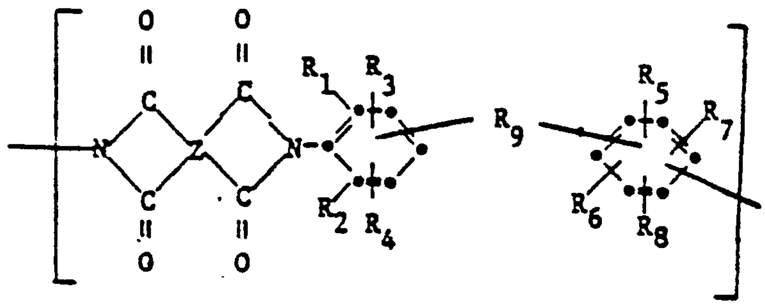

(Ib)

and 50 to 0 mol % of recurring structural elements of the formula II

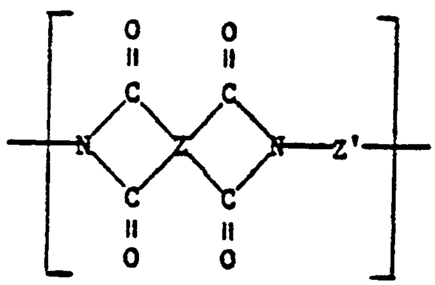

(II)

and (c) at least 0.1 % by weight, based on component (b), of at least one organic chromophoric polyazide in which the azide groups are bonded to aromatic hydrocarbon radicals either directly or via an $SO_2$ group, the four carbonyl groups in the formulae Ia, Ib and II being bonded to different carbon atoms and any two carbonyl groups being in ortho- or peri-position relative to each other, Z being a tetravalent radical which contains at least one aromatic ring, Z' being a divalent organic radical which differs from the groups of the formulae

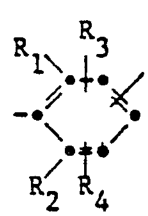

or

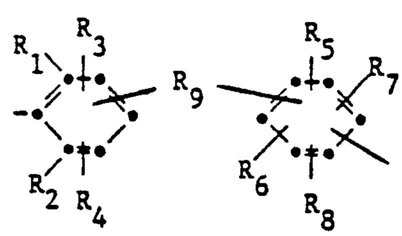

and is selected from among aromatic, alkylaromatic, aliphatic, cycloaliphatic and heterocyclic radicals, combinations thereof and radicals having oxygen-, sulfur-, nitrogen-, silicon- or phosphorus-containing bridge groups, $R_1$ and $R_2$, independently of each other, each being alkyl having 1-4 C atoms, $R_3$, $R_4$, $R_5$, $R_6$, $R_7$ and $R_8$, independently of one another, each being hydrogen or alkyl having 1-4 C atoms and $R_9$ being a direct bond, -O-, -S-, -SO-, -S-S-, $-SO_2-$, -CO- -COO-, -NH-,

-N-alkyl

having 1-6 C atoms in the alkyl,

-N-phenyl, -N-benzyl,

-CONH-,

-CON-alkyl

having 1-6 C atoms in the alkyl,

-CON-phenyl, -CON-benzyl,

a linear or branched alkylene group having 1-3 C atoms, alkylidene having 2-12 C atoms, cycloalkylidene having 5-6 ring carbon atoms, phenylene,

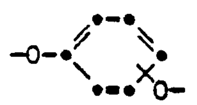 or an $R_{10}Si-R_{11}$ group in which $R_{10}$ and $R_{11}$

are each alkyl or alkoxy having 1-6 C atoms each, phenyl, benzyl, phenyloxy or benzyloxy.

2. Radiation-sensitive coating agent according to claim 1, in which the azide groups of the chromophoric polyazide are bonded to aromatic hydrocarbon radicals via direct bonds.

3. Radiation-sensitive coating agent according to claim 1, in which Z is one or more of the structures

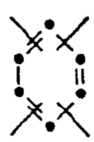
(1),

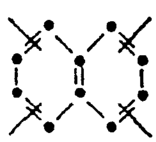
(2),

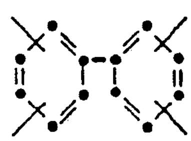
(3),

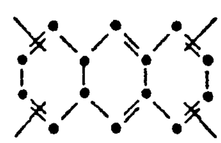
(4),

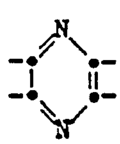
(5),

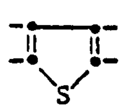
(6),

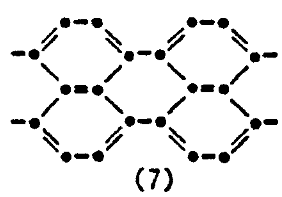
(7),

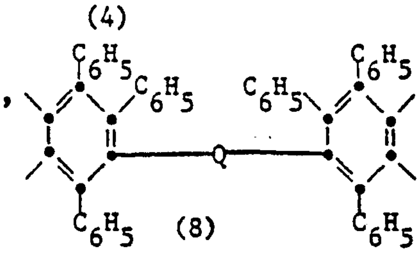
(8),

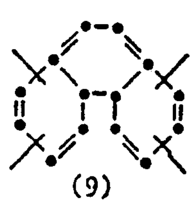
(9)

or

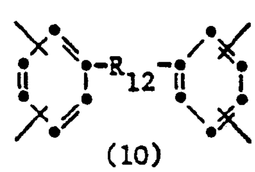
(10)

in which Q is 1,3- or 1,4-phenylene or a diphenyl ether radical and $R_{12}$ is selected from the group consisting of

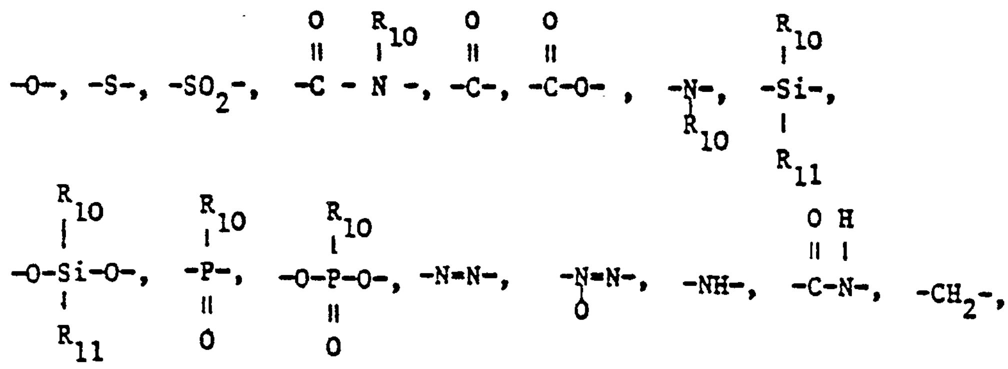

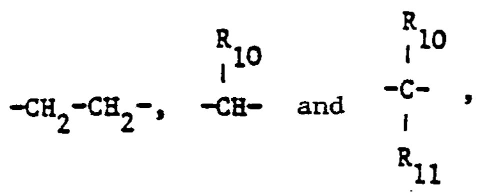

where $R_{10}$ and $R_{11}$ are as defined in claim 1.

4. Radiation-sensitive coating agent according to claim 1, in which Z is the radical of pyromellitic acid dianhydride, a radical of the formula VI

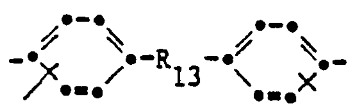

(VI)

or a mixture of these radicals, in which $R_{13}$ is a direct bond, $-CH_2-$, -O-, $-SO_2-$ or -CO-.

5. Radiation-sensitive coating agent according to claim 1, in which Z is the radical of pyromellitic acid dianhydride, a radical of the formula VIa

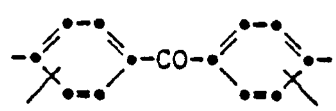

(VIa)

or a mixture of these radicals.

6. Radiation-sensitive coating agent according to claim 1, in which $R_1$ and $R_2$, independently of each other, are each methyl or ethyl, $R_3$ to $R_8$, independently of one another, are each hydrogen, methyl or ethyl, and $R_9$ is $-CH_2-$, -O-, -CO- or a direct bond.

7. Radiation-sensitive coating agent according to claim 1, in which $R_1$ and $R_2$ are both ethyl and in particular methyl and $R_3$ and $R_4$, independently of each other, are each hydrogen or methyl, the free bond being in the meta- or in particular in the para-position relative to the N atom.

8. Radiation-sensitive coating agent according to claim 1, in which the structural elements of the formula Ia are derived from diamines of the formulae A, B, C or D

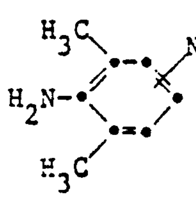 (A), 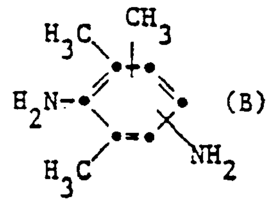 (B) ,

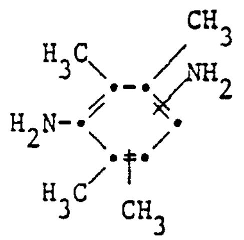 (C) or 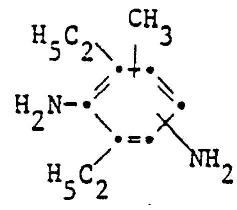 (D)

or mixtures thereof in which the amino groups are in the meta- and especially in the para-position relative to each other.

9. Radiation-sensitive coating agent according to claim 1, in which the structural elements of the formula Ib are derived from symmetrical diamines of the formula III

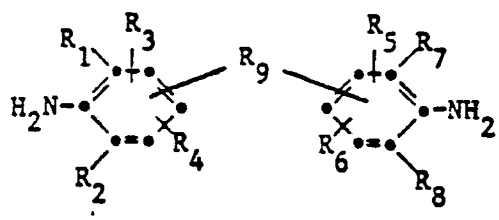 (III)

in which $R_9$ is as defined in claim 1 and is in particular a direct bond, $-CH_2-$ or -CO-, $R_1$, $R_2$, $R_7$ and $R_8$ are all $C_{1-4}$-alkyl, and $R_3$ and $R_5$ on the one hand and $R_4$ and $R_6$ on the other are defined the same way and are each hydrogen or $C_{1-4}$-alkyl.

10. Radiation-sensitive coating agent according to claim 1, in which the structural elements of the formula Ib are derived from diamines of the formula IIIa

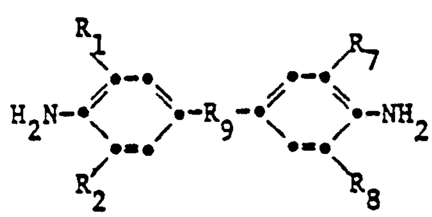 (IIIa)

in which $R_1$ and $R_7$ are each methyl, $R_2$ and $R_8$ are each ethyl or especially methyl, and $R_9$ is a direct bond, -CO- or in particular - $CH_2$-.

11. Radiation-sensitive coating agent according to claim 1, in which homopolyimide or copolyimide (b) essentially comprises 70 to 100 mol % of recurring structural elements of the formula Ia or Ib or mixtures thereof and 30 to 0 mol % of recurring structural elements of the formula II in which Z is the radical of pyromellitic acid dianhydride, a radical of the formula VI

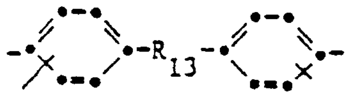

(VI)

or a mixture of these radicals, $R_1$ and $R_2$, independently of each other, are each methyl or ethyl, $R_3$ to $R_8$, independently of one another, are each hydrogen, methyl or ethyl, and $R_9$ is $-CH_2-$, -O-, -CO or a direct bond, and Z' is a radical of the formula IX or X

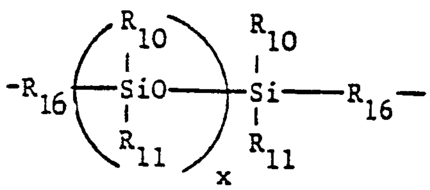

(IX) or

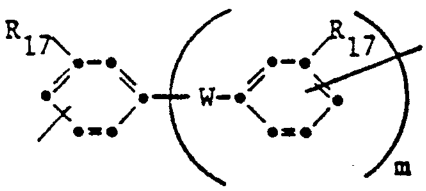

(X)

in which $R_{13}$ is a direct bond, $-CH_2-$, -O-, $SO_2-$ or -CO-, m is zero or 1, x is an integer from 1 to 50, $R_{16}$ is alkylene having 1-6 C atoms, $R_{17}$ is a hydrogen atom, alkyl or alkoxy having 1-5 C atoms, the free bonds in the formula X are in the meta- and preferably in the ortho-position relative to the $R_{17}$ group, W is a direct bond, -S-, -CO-, -NH-,

N-alkyl

having 1-5 C atoms in the alkyl, -O-, -SO-, -S-S-,

-N-phenyl,

$-SO_2-$, a linear or branched alkylene group having 1-3 C atoms, alkylidene having 2-12 C atoms, cycloalkylidene having 5 or 6 ring carbon atoms, phenylene or an

$R_{10}$-Si-$R_{11}$

group, and $R_{10}$ and $R_{11}$ are each alkyl or alkoxy having 1-6 C atoms, phenyl, benzyl, phenyloxy or benzyloxy.

**12.** Radiation-sensitive coating agent according to claim 11, in which homopolyimide or copolyimide (b) essentially comprises 70 to 100 mol % of recurring structural elements of the formula Ia or Ib or mixtures thereof and 30 to 0 mol % of recurring structural elements of the formula II in which Z is the radical of pyromellitic acid dianhydride, a radical of the formula VIa

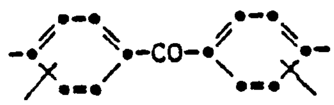

(VIa)

or a mixture of these radicals and in which the structural elements of the formula Ia are derived from diamines of the formulae A, B, C or D

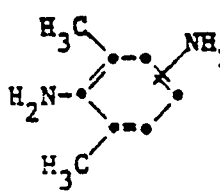

(A),

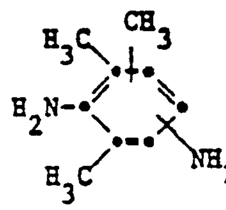

(B) ,

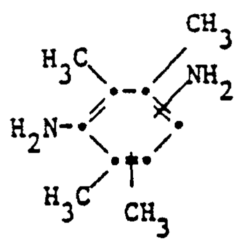

(C) or

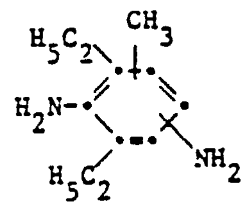

(D)

or mixtures thereof and structural elements of the formula Ib are derived from diamines of the formula IIIa

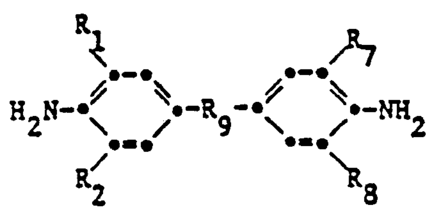

(IIIa)

where the amino groups in the formulae A, B, C and D are in the meta-and especially in the para-position relative to each other, $R_1$ and $R_7$ are each methyl, $R_2$ and $R_8$ are each ethyl or especially methyl, $R_9$ is a direct bond or -CO- or in particular $-CH_2-$, Z' is a radical of the formula X in which m is zero or I, W is a direct bond, -CO- or $-CH_2-$or in particular -O- and $R_{17}$ is a hydrogen atom.

**13.** Radiation-sensitive coating material according to claim 11, in which homopolyimide or copolyimide (b) essentially comprises 70 to 100 mol % of recurring structural elements of the formula Ia or Ib or mixtures thereof and 30 to 0 mol % of recurring structural elements of the formula II in which Z is the radical of pyromellitic acid dianhydride, a radical of the formula VIa

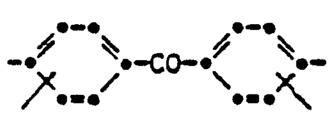

(VIa)

or a mixture of these radicals and in which the structural elements of the formula Ia are derived from diamines of the formulae A, B, C or D

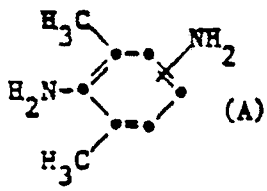 (A), 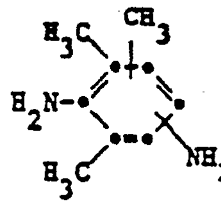 (B) ,

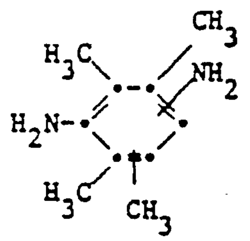 (C) or 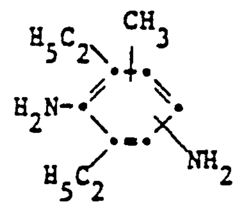 (D)

or mixtures thereof and the structural elements of the formula Ib are derived from diamines of the formula IIIa

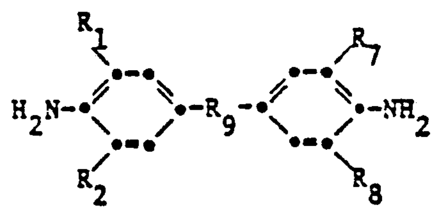 (IIIa)

where the amino groups in the formulae A, B, C and D are in the meta-and especially in the para-position relative to each other, $R_1$ and $R_7$ are each methyl, $R_2$ and $R_8$ are each ethyl or especially methyl, $R_9$ is a direct bond or -CO- or in particular $-CH_2-$ and Z' is a radical of the formula IX in which x is 1, the $R_{10}$s and $R_{11}$s are all methyl, and $R_{16}$ is alkylene having 1-6 or in particular 3 C atoms.

**14.** Radiation-sensitive coating agent according to claim 11, in which homopolyimide or copolyimide (b) comprises 100 mol % of recurring structural elements of the formula Ia or Ib or mixtures thereof, Z is the radical of pyromellitic acid dianhydride, a radical of the formula VIa

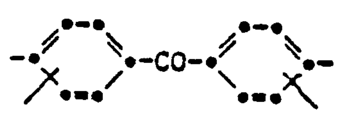 (VIa)

or a mixture of these radicals, and in which the structural elements of the formula Ia are derived from diamines of the formulae A, B, C or D

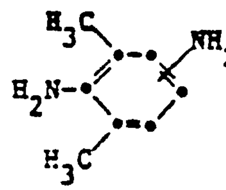 (A), 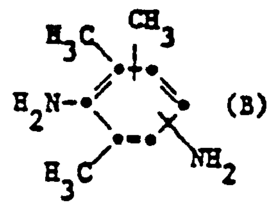 (B) ,

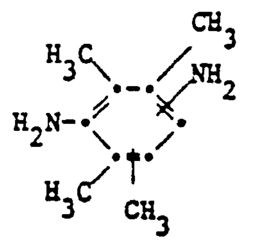 (C) or 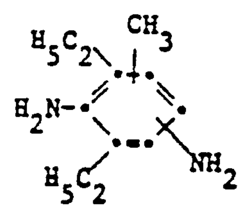 (D)

or mixtures thereof and the structural elements of the formula Ib are derived from 4,4'-diamino-3,5,3'5'-tetramethyldiphenylmethane.

**15.** Coating agent according to claim 1, which contains 99.9 to 80 % by weight of polyimide (b) and 0.1 to 20 % by weight of polyazide (c), based on components (b) and (c).

**16.** Coating agent according to claim 1, wherein the solvent is a polar aprotic solvent.

**17.** Coating agent according to claim 1, wherein the chromophoric polyazide is a bisazide of the formula XII

$N_3$-E-(Y)$_q$-E-$N_3$ (XII)

in which E is an aromatic hydrocarbon radical, q is 0 or 1, and Y is an inorganic or organic group which, together with the aromatic hydrocarbon radicals E, forms a mesomeric system.

**18.** Coating agent according to claim 17, in which Y is O, CO, S, SO, $SO_2$, NR' where R' is hydrogen, alkyl, cycloalkyl, aryl or aralkyl,

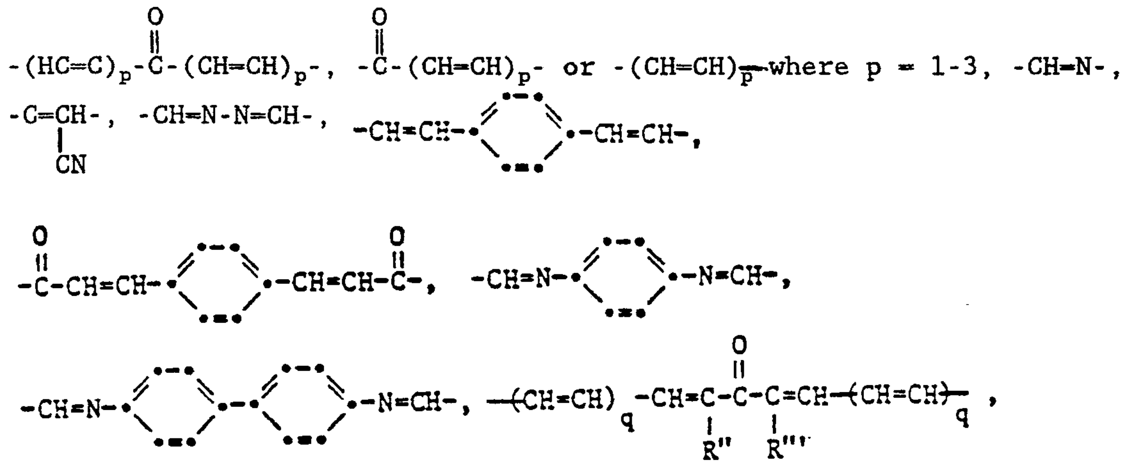

or where p = 1-3,

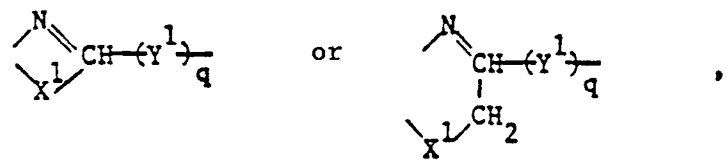

or ,

in which R'' and R''', independently of each other, are each alkyl having 1 to 5 C atoms or R'' and R''' together are unsubstituted or alkyl-, hydroxyalkyl-, alkoxy-, trialkylsilyl-, hydroxyl-, carboxyl-, alkoxycarbonyl-, amino-, alkylamino- or dialkylamino-substituted ethylene or trimethylene, q is 0 or 1, $X^1$ is 0, S or NH, $Y^1$ is independently defined in the same way as Y, and the free bonds on N and $X^1$, together with the E group, form a fused heterocyclic ring.

**19.** Coating agent according to claim 1 wherein the polyazide is 2,6-bis(4-p-azidobenzylidene)-4-methylcyclohexan-l-one.

**20.** Photographic recording material for relief images, containing a carrier to which is applied a radiation-sensitive layer in the form of a mixture of polyimide (b) and polyazide (c) as claimed in claim 1.

**21.** Use of coating agents according to claim 1 for the application of insulating and protective coatings and in particular for producing printed circuits, discrete semiconductor devices and integrated circuits.

## Revendications

**1.** Produit pour enduction ou revêtement sensible à un rayonnement, ce produit contenant (a) un solvant organique ; (b) un homopolyimide ou un copolyimide soluble dans ce solvant et qui consiste essentiellement en 50 à 100 moles % d'éléments structurels récurrents répondant aux formules Ia et/ou Ib :

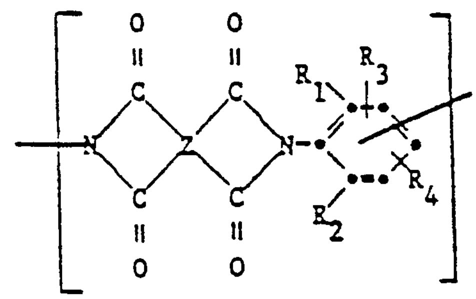

(Ia) et/ou

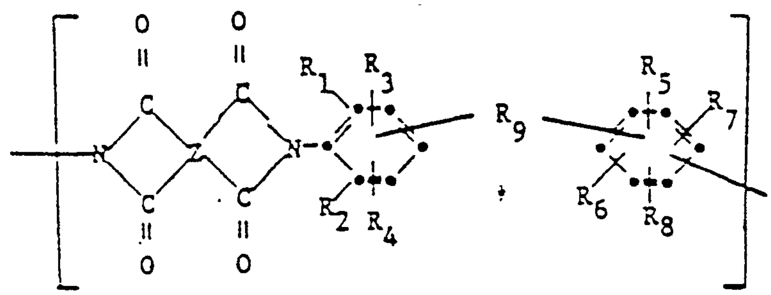

(Ib)

et 50 à 0 mole % d'éléments structurels récurrents de formule II

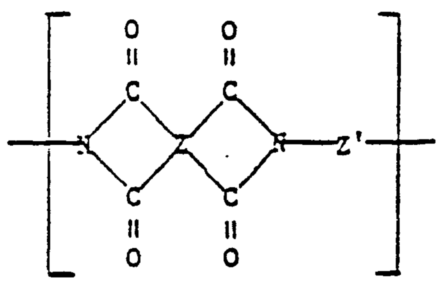

(II)

et (c) au moins 0,1 % en poids, par rapport au composant (b) d'au moins un polyazide chromophore organique, dans lequel les groupes azides sont reliés, directement ou par l'intermédiaire d'un groupe $SO_2$, à des hydrocarbures aromatiques, et, dans les formules Ia, Ib et II, les quatre groupes carbonyles sont fixés sur différents atomes de carbone et deux groupes carbonyles sont à chaque fois placés en position ortho ou péri l'un par rapport à l'autre,

z représente un reste tétravalent, qui contient au moins un noyau aromatique,

Z' représente un reste organique divalent qui diffère des groupes

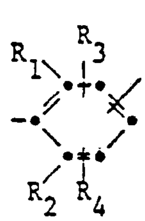

ou

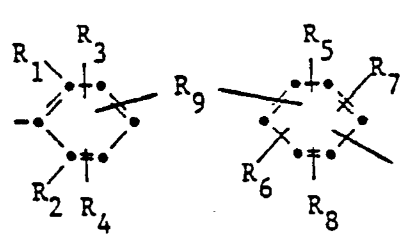

reste choisi parmi des restes aromatiques, alkyl aromatiques, aliphatiques, cycloaliphatiques et hétérocycliques, leurs combinaisons et des restes de groupes de pontage comportant de l'oxygène, du soufre, de l'azote, du silicium ou du phosphore,

$R_1$ et $R_2$ représentent chacun, indépendamment l'un de l'autre, un groupe alkyle ayant 1 à 4 atomes

de C, $R_3$, $R_4$, $R_5$, $R_6$, $R_7$ et $R_8$ représentent chacun, indépendamment l'un de l'autre, un atome d'hydrogène ou un groupe alkyle ayant 1 à 4 atomes de carbone, et $R_9$ représente une liaison directe, -O-, -S-, un groupe -SO-, -S-S-, $SO_2$, -CO- -COO-, -NH-, -N-alkyle ayant 1 à 6 atomes de carbone dans le groupe alkyle, un groupe

|　　　|
—N— phényle, —N—benzyle,

-CONH-,

|
—CON—alkyle

ayant 1 à 6 atomes de carbone dans le groupe alkyle,

|
—CON—phényle,

|
—CON—benzyle,

un groupe alkylène linéaire ou ramifié ayant 1 à 3 atomes de C, un groupe alkylidène ayant 2 à 12 atomes de C, cycloalkylidène ayant 5 à 6 atomes de carbone de noyau, un groupe phénylène,

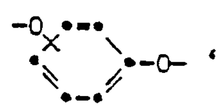

ou un groupe

|
$R_{10}$Si—$R_{11}$,
|

où $R_{10}$ et $R_{11}$ représentent chacun un groupe alkyle ou alcoxy ayant chacun 1 à 6 atomes de carbone, un groupe phényle, benzyle, phényloxy ou benzyloxy.

2. Produit pour revêtement sensible à un rayonnement, selon la revendication 1, dans lequel les groupes azides du polyazide chromophore sont fixés directement sur des restes hydrocarbonés aromatiques.

3. Produit de revêtement sensible à un rayonnement, selon la revendication 1, dans lequel Z correspond à une ou plusieurs des structures

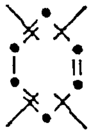 , 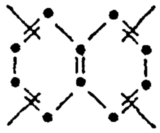 , 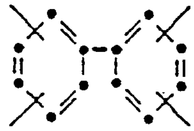 , 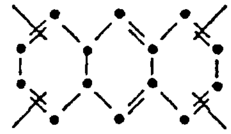 ,

(1) (2) (3) (4)

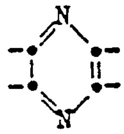 , 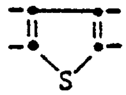 ,

(5) (6)

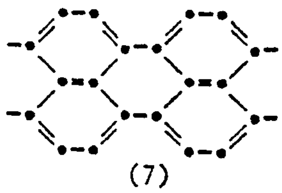 , 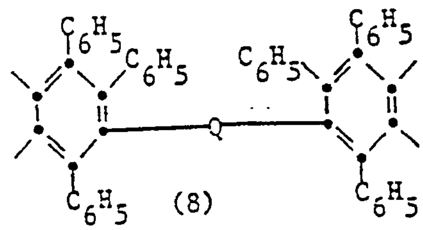 ,

(7) (8)

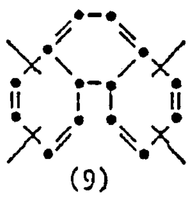 ou 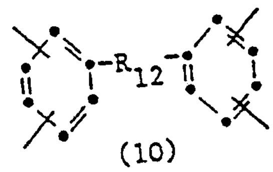

(9) (10)

dans lesquelles Q représente un groupe phénylène-1,3 ou phénylène-1,4 ou un reste oxyde de diphényle, et $R_{12}$ est choisi parmi l'ensemble consistant en

$-O-$, $-S-$, $-SO_2-$, 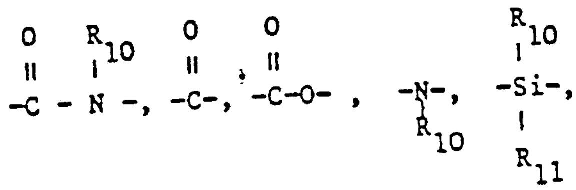

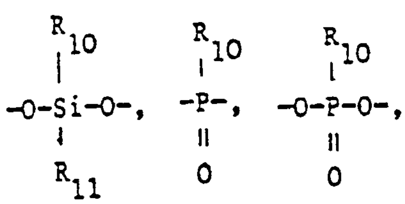 $-N{=}N-$, 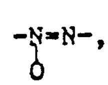 $-NH-$, 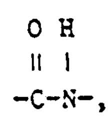 $-CH_2-$,

$-CH_2-CH_2-$, 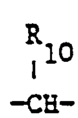 et 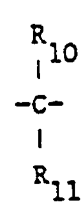 ,

où $R_{10}$ et $R_{11}$ ont le sens indiqué à la revendication 1.

**4.** Produit pour revêtement sensible à un rayonnement, selon la revendication 1, dans lequel Z représente le reste du dianhydride de l'acide pyromellitique, un reste de formule VI

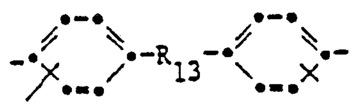

(VI)

ou bien un mélange de ces restes, dans lequel $R_{13}$ représente une liaison directe, un groupe $-CH_2-$, -O- ou $-SO_2-$ ou -CO-.

**5.** Produit pour revêtement sensible à un rayonnement, selon la revendication 1, dans lequel z représente le reste du dianhydride de l'acide pyromellitique, un reste de formule VIa,

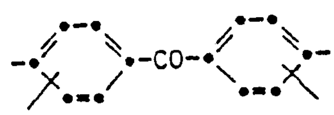

(VIa)

ou un mélange de ces restes.

**6.** Produit pour revêtement sensible à un rayonnement, selon la revendication 1, dans lequel $R_1$ et $R_2$ représentent chacun, indépendamment l'un de l'autre, un groupe méthyle ou éthyle, les symboles $R_3$ à $R_8$ représentent chacun, indépendamment l'un de l'autre, un atome d'hydrogène, un groupe méthyle ou éthyle, et $R_9$ représente un groupe $-CH_2-$ -O-, -CO- ou une liaison directe.

**7.** Produit pour revêtement sensible à un rayonnement, selon la revendication 1, dans lequel $R_1$ et $R_2$ représentent chacun un groupe éthyle et en particulier chacun un groupe méthyle, et $R_3$ et $R_4$ représentent chacun, indépendamment l'un de l'autre, un atome d'hydrogène ou un groupe méthyle, la liaison libre se trouvant en méta ou notamment en para par rapport à l'atome de N.

**8.** Produit pour revêtement sensible à un rayonnement, selon la revendication 1, dans lequel les éléments structurels de formule Ia dérivent de diamines répondant aux formules A, B, C ou D

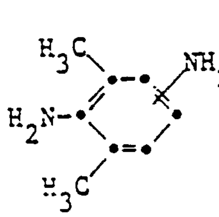

(A),

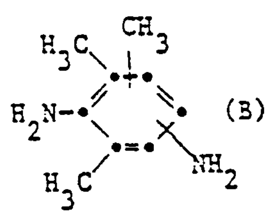

(B) ,

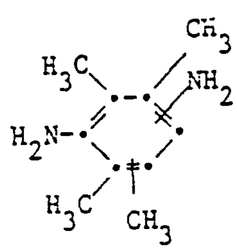

(C)

ou

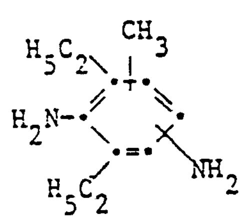

(D)

ou de leurs mélanges, les groupes amino se trouvant en position méta ou surtout en position para l'un par rapport à l'autre.

**9.** Produit pour revêtement sensible à un rayonnement, selon la revendication 1, dans lequel les éléments structurels de formule Ib dérivent de diamines symétriques de formule III

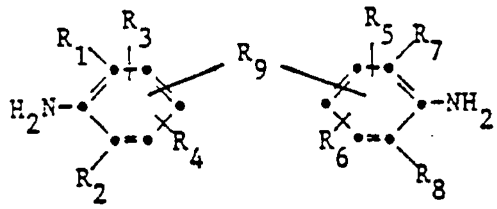

(III)

dans laquelle $R_9$ a le sens indiqué à la revendication 1 et représente notamment une liaison directe, un groupe $-CH_2$-ou -CO- ; $R_1$, $R_2$, $R_7$ et $R_8$ représentent chacun un groupe alkyle ayant 1 à 4 atomes de carbone ; $R_3$ et $R_5$ ou bien $R_4$ et $R_6$ ont le même sens et représentent chacun un atome d'hydrogéne ou un groupe alkyle en $C_1$ à $c_4$.

**10.** Produit pour revêtement sensible à un rayonnement, selon la revendication 1, dans lequel les éléments structurels de formule Ib dérivent de diamines de formule IIIa :

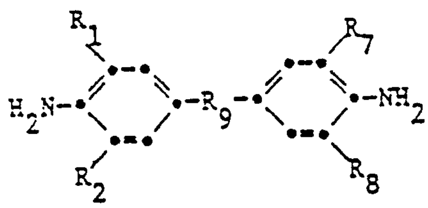

(IIIa)

(dans laquelle $R_1$ et $R_7$ représentent chacun un groupe méthyle, $R_2$ et $R_8$ représentent chacun un groupe éthyle et surtout un groupe méthyle, et $R_9$ représente une liaison directe, -CO- et en particulier $-CH_2$-).

**11.** Produit pour revêtement sensible à un rayonnement, selon la revendication 1, dans lequel l'homopolyimide ou le copolyimide (b) consiste essentiellement en 70 à 100 moles % d'éléments structurels récurrents de formule Ia ou Ib ou de leurs mélanges et en 30 à 0 mole % d'éléments structurels récurrents de formule II, où Z représente le reste du dianhydride de l'acide pyromellitique, un reste de formule VI

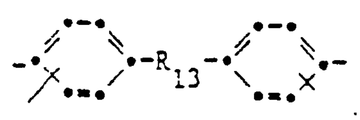

(VI)

ou un mélange de ces restes ; $R_1$ et $R_2$ représentent, indépendamment l'un de l'autre, un groupe méthyle ou éthyle ; $R_3$ à $R_8$ représentent chacun, indépendamment l'un de l'autre, un atome d'hydrogène, un groupe méthyle ou éthyle, et $R_9$ représente $-CH_2$-, -O-, -CO- ou une liaison directe, et Z' représente un reste de formule LX ou X

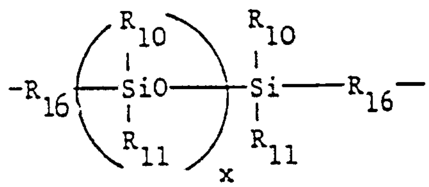 (IX) ou

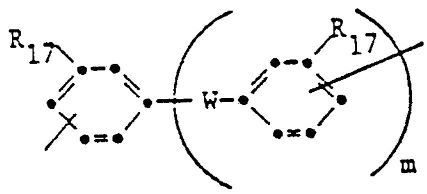 (X)

formules dans lesquelles $R_{13}$ représente une liaison directe, un groupe $-CH_2-$, -O-, $-SO_2-$ ou -CO- ; m est nul ou vaut 1 ; X est un nombre entier valant 1 à 50 ; $R_{16}$ représente un groupe alkylène ayant 1 à 6 atomes de carbone, $R_{17}$ représente un atome d'hydrogène, un groupe alkyle ou alcoxy ayant 1 à 5 atomes de carbone, les liaisons libres apparaissant dans la formule X se trouvent en position méta et de préférence en position ortho par rapport au groupe $R_{17}$ ; W représente une liaison directe, -S-, -CO-, -NH-,

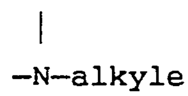

ayant 1 à 5 atomes de carbone dans la partie alkyle, -O-, -SO-, -S-,

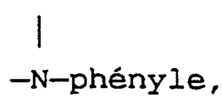

$-SO_2-$, un groupe alkylène linéaire ou ramifié ayant 1 à 3 atomes de carbone, alkylidène ayant 2 à 12 atomes de carbone, cycloalkylidène ayant 5 ou 6 atomes de carbone de noyau, phénylène ou un groupe

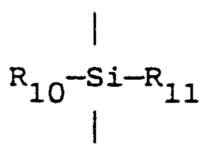 ,

et $R_{10}$ et $R_{11}$ représentent chacun un groupe alkyle ou alcoxy ayant 1 à 6 atomes de carbone, phényle, benzyle, phényloxy ou benzyloxy.

**12.** Produit pour revêtement sensible à un rayonnement, selon la revendication 11, dans lequel l'homopolyimide ou le copolyimide (b) consiste essentiellement en 70 à 100 moles % d'éléments structurels récurrents de formule Ia ou Ib ou en leurs mélange et en 30 à 0 mole % d'éléments structurels récurrents de formule II, où Z représente le reste du dianhydride de l'acide pyromellitique, un reste de formule VIa

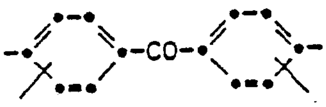 (VIa)

ou un mélange de ces restes, et les éléments structurels de formule Ia dérivent de diamines répondant aux formules A, B, C ou D

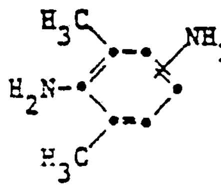 (A), 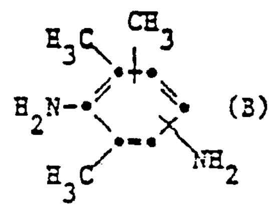 (B) ,

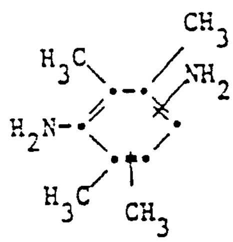 (C) ou 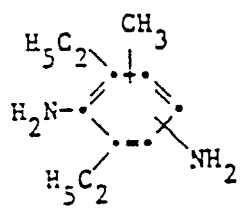 (D)

ou de leurs mélanges, et les éléments structurels de formule Ib dérivent de diamines de formule IIIa

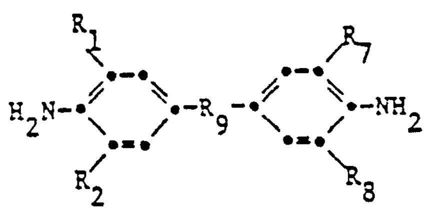 (IIIa)

et les groupes amino présents dans les formules A, B, C et D sont en position méta et surtout en position para l'un par rapport à l'autre ; $R_1$ et $R_7$ représentent chacun un groupe méthyle ; $R_2$ et $R_8$ représentent chacun un groupe éthyle et surtout méthyle ; $R_9$ représente une liaison directe ou -CO- et en particulier -CH- ; et Z' représente un reste de formule X, m est nul ou vaut 1 ; W est une liaison directe ou représente -CO- ou $-CH_2-$ et en particulier -O-, et $R_{17}$ représente un atome d'hydrogène.

**13.** Produit pour revêtement sensible à un rayonnement, selon la revendication 1, dans lequel l'homopolyimide ou le copolyimide (b) consiste essentiellement en 70 à 100 moles % d'éléments structurels récurrents de formule Ia ou Ib ou en leurs mélanges, et en 30 à 0 mole % d'éléments structurels récurrents de formule II, le symbole Z représentant le reste du dianhydride de l'acide pyromellitique, un reste de formule VIa

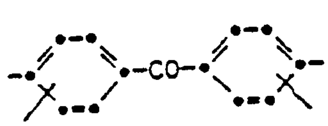 (VIa)

ou un mélange de ces restes, et les éléments structurels de formule La dérivent de diamines répondant aux formules A, B, C ou D

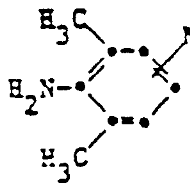 (A), 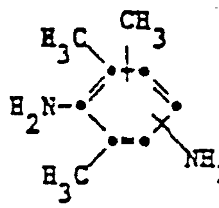 (B) ,

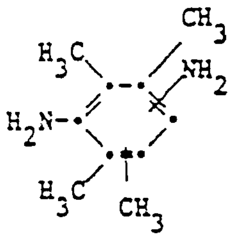 (C) ou 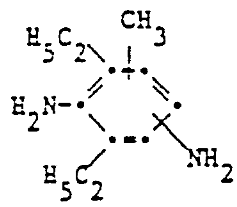 (D)

ou de leurs mélanges, et les éléments structurels de formule Ib dérivent de diamines de formule IIIa

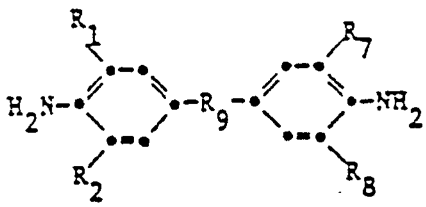 (IIIa)

les groupes amino présents dans les formules A, B, C et D étant en position méta et surtout en position para l'un par rapport à l'autre ; $R_1$ et $R_7$ représentent chacun un groupe méthyle ; $R_2$ et $R_8$ représentent chacun un groupe éthyle et surtout méthyle ; $R_9$ est une liaison directe ou représente -CO- et en particulier $-CH_2-$ ; et Z' est un reste de formule IX, x vaut 1 ; les symboles $R_{10}$ et $R_{11}$ représentent chacun un groupe méthyle et $R_{16}$ représente un groupe alkylène ayant 1 à 6 et, notamment, ayant 3 atomes de carbone.

**14.** Produit pour revêtement sensible à un rayonnement, selon la revendication 11, dans lequel l'homopolyimide ou le copolyimide (b) consiste en 100 moles % d'éléments structurels récurrents de formule Ia ou Ib ou en leurs mélanges ; Z représente le reste du dianhydride de l'acide pyromellitique, un reste de formule VIa

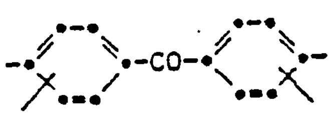 (VIa)

ou un mélange de ces restes ; et les éléments structurels de formule Ia dérivent de diamines répondant aux formules A, B, C ou D

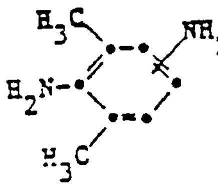 (A), 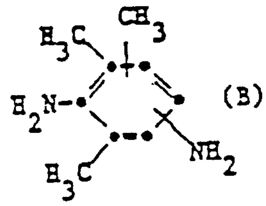 (B) ,

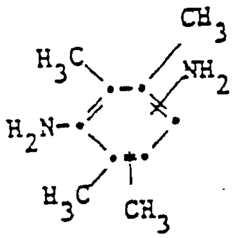 (C) ou 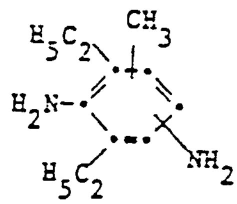 (D)

ou de leurs mélanges, et les éléments structurels de formule Ib dérivent du diamino-4,4' tétraméthyl-3,5,3',5' diphénylméthane.

**15.** Produit pour revêtement selon la revendication I, caractérisé en ce qu'il contient 99,9 à 80 % en poids du polyimide (b) et 0,1 à 20 % en poids du polyazide (c), par rapport aux constituants (b) et (c).

**16.** Produit pour revêtement selon la revendication I, caractérisé en ce que le solvant est un solvant aprotique polaire.

**17.** Produit pour revêtement selon la revendication 1, caractérisé en ce que le polyazide chromophore est un bisazide de formule XII

$N_3$-E-$(Y)_q$-E-$N_3$ (XII)

dans laquelle E représente un reste d'hydrocarbure aromatique ; q vaut 0 ou 1 ; et Y est un groupe minéral ou organique qui, avec les restes hydrocarbonés aromatiques E, forme un système mésomère.

**18.** Produit pour revêtement selon la revendication 17, dans lequel Y représente O, CO, S, SO, $SO_2$, NR' dans lequel R' représente un atome d'hydrogène, un groupe alkyle, cycloalkyle, aryle ou aralkyle ;

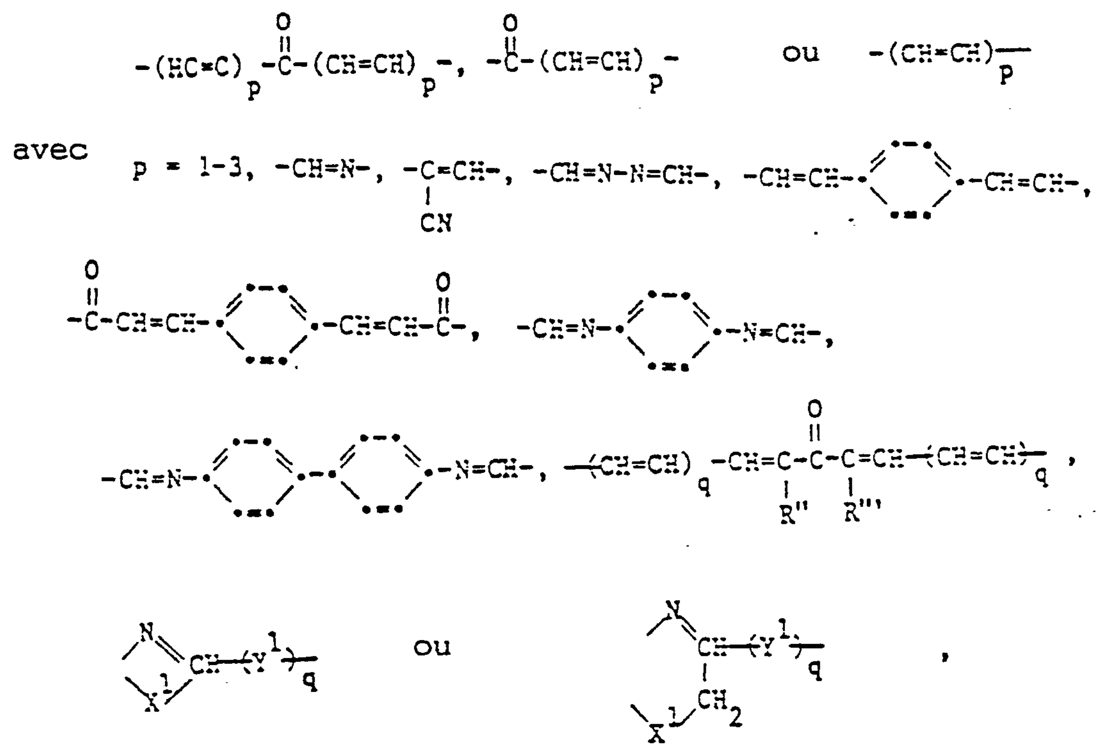

avec ... ou ... ,

formules dans lesquelles R'' et R''' représentent, indépendamment l'un de l'autre, un groupe alkyle ayant 1 à 5 atomes de carbone ou bien R'' et R''' forment ensemble un groupe éthylène ou triméthylène (non substitué ou substitué par un groupe alkyle, hydroxyalkyle, alcoxy, trialkylsilyle, hydroxy, carboxyle, alcoxycarbonyle, amino, alkylamino ou dialkylamino); q vaut 0 ou 1 ; $X^1$ represente O, S ou NH ; chaque $Y^1$ a, indépendamment, le même sens que Y, et les liaisons libres sur N et $Y^1$ forment, avec le groupe E, un noyau hétérocyclique condensé.

**19.** Produit pour revêtement selon la revendication 1, caractérisé en ce que le polyazide est la bis(p-azido-4 benzylidène)-2,6 méthyl-4 cyclohexanone-l.

**20.** Matière pour impression photographique pour des images en relief, contenant un support sur lequel est appliqué, comme couche sensible à un rayonnement, un mélange du polyimide (b) et du polyazide (c) selon la revendication 1.

**21.** Utilisation des produits pour revêtement selon la revendication 1 pour appliquer des vernis d'isolement et de protection et notamment pour produire des circuits imprimés, des composants ou modules semiconducteurs "discrets" ou séparés, et des circuits intégrés de commande ou de commutation.